(19) Europäisches Patentamt
European Patent Office
Office européen des brevets

(11) **EP 4 297 309 B1**

(12) **EUROPEAN PATENT SPECIFICATION**

(45) Date of publication and mention
of the grant of the patent:
**24.09.2025  Bulletin 2025/39**

(21) Application number: **22766235.0**

(22) Date of filing: **04.03.2022**

(51) International Patent Classification (IPC):
$H03M\ 13/25^{(2006.01)}$  $H04L\ 1/00^{(2006.01)}$
$H03M\ 13/13^{(2006.01)}$  $H04L\ 27/02^{(2006.01)}$

(52) Cooperative Patent Classification (CPC):
**H04L 1/0042; H03M 13/13; H03M 13/251;
H04L 1/0071; H04L 27/02**

(86) International application number:
**PCT/CN2022/079301**

(87) International publication number:
**WO 2022/188710 (15.09.2022 Gazette 2022/37)**

(54) **POLARIZATION ENCODING AND MODULATION METHOD AND APPARATUS, AND DEMODULATION AND DECODING METHOD AND APPARATUS**

VERFAHREN UND VORRICHTUNG ZUR POLARISATIONSKODIERUNG UND -MODULATION SOWIE VERFAHREN UND VORRICHTUNG ZUR DEMODULATION UND DEKODIERUNG

PROCÉDÉ ET APPAREIL DE CODAGE ET DE MODULATION DE POLARISATION AINSI QUE PROCÉDÉ ET APPAREIL DE DÉMODULATION ET DE DÉCODAGE

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: **10.03.2021  CN 202110262605**

(43) Date of publication of application:
**27.12.2023  Bulletin 2023/52**

(73) Proprietor: Huawei Technologies Co., Ltd.
Shenzhen, Guangdong 518129 (CN)

(72) Inventors:
• WANG, Xianbin
Shenzhen, Guangdong 518129 (CN)
• LI, Yuan
Shenzhen, Guangdong 518129 (CN)
• ZHANG, Huazi
Shenzhen, Guangdong 518129 (CN)
• LI, Rong
Shenzhen, Guangdong 518129 (CN)
• WANG, Jun
Shenzhen, Guangdong 518129 (CN)

(74) Representative: **Pfenning, Meinig & Partner mbB
Patent- und Rechtsanwälte
Theresienhöhe 11a
80339 München (DE)**

(56) References cited:
WO-A1-2019/197037      CN-A- 109 155 691
CN-A- 111 385 059      CN-A- 112 019 298
US-A1- 2015 092 886

• ZHOU DEKUN ET AL: "Constellation shaping for bit-interleaved polar coded-modulation", 2016 IEEE 27TH ANNUAL INTERNATIONAL SYMPOSIUM ON PERSONAL, INDOOR, AND MOBILE RADIO COMMUNICATIONS (PIMRC), IEEE, 4 September 2016 (2016-09-04), pages 1 - 5, XP033035329, DOI: 10.1109/PIMRC.2016.7794697
• ONURCAN ISCAN ET AL: "Shaped Polar Codes for Higher Order Modulation", IEEE COMMUNICATIONS LETTERS., vol. 22, no. 2, February 2018 (2018-02-01), US, pages 252 - 255, XP055462442, ISSN: 1089-7798, DOI: 10.1109/LCOMM.2017.2766621

**Description**

**TECHNICAL FIELD**

This application relates to the field of communication, and in particular, to a polar encoding and modulation method and apparatus, a demodulation and decoding method and apparatus, a communication apparatus and computer program product.

**BACKGROUND**

Polar code (Polar code) is a structured channel coding method that is theoretically proved to be capable of achieving a channel capacity, and has characteristics such as good performance and low complexity. In recent years, as a polar code is listed in a 5th-generation (5th-generation, 5G) mobile communication technology standard, design of a polar code modulation scheme has also become a hot issue in a communication direction. Through modulation, a binary polar code codeword bit may be mapped into a real-number symbol, and then sent to a receiver by using a channel.

To further improve spectral efficiency, a high-order modulation technology can be used to map a plurality of codeword bits to a same channel symbol. In a high-order modulation scenario, energy of different symbols is different. By using a current shaping technology, more low-energy symbols can be sent and fewer high-energy symbols can be sent, thereby saving average energy.

However, in the high-order modulation scenario, even if a relatively simple probability shaping technology is combined with a polar code, problems such as incompatibility, high complexity, and limited flexibility exist. WO2019197037A1 discloses an encoder for encoding a message into channel input symbols. The encoder is configured to divide the message for obtaining message parts, encode the message parts into encoded parts such that at least one encoded part has a non-uniform distribution, map the encoded parts into the channel input symbols. A channel input symbol is based on a plurality of encoded parts.

Zhou Dekun et al: "Constellation shaping for bit-interleaved polar coded-modulation", 27th annual international symposium on personal, indoor, and mobile radio communications (PIMRC), IEEE, 4 September 2016, pages 1-5, XP033035329 discloses a method for constellation shaping in bit-interleaved polar coded modulation (BIPCM).

**SUMMARY**

This application provides a polar encoding and modulation method and apparatus, and a demodulation and decoding method and apparatus, to implement sub-channel capacity matching through flexible check, and maximize a transmission rate.

The invention is defined in the appended set of claims. The following aspects do not correspond to the claims but, together with the appended comments, are useful to understand the invention. . According to a first aspect, a polar encoding and modulation method is provided, including: grouping to-be-encoded bit sequences to obtain a first bit sequence and a second bit sequence, where a quantity of bits included in the first bit sequence is greater than or equal to zero, and a quantity of bits included in the second bit sequence is greater than or equal to zero; mapping the second bit sequence to obtain a third bit sequence; performing polar transformation on the first bit sequence and a fourth bit sequence to obtain a fifth bit sequence, where the fourth bit sequence is obtained by performing polar transformation on the third bit sequence; modulating the third bit sequence and the fifth bit sequence to obtain a modulation symbol sequence; and sending the modulation symbol sequence.

It should be understood that, in this technical solution, the to-be-encoded bits are divided into two groups. One group is the first bit sequence, and the other group is a second bit sequence. Each group may include one or more bit sequences, and the two groups of bit sequences are independent of each other. In other words, the second bit sequence is not generated based on the first bit sequence, and vice versa. Then, probability shaping and polar transformation are respectively performed on the second bit sequence to obtain the third bit sequence, and the third bit sequence is modulated. The fourth bit sequence is obtained based on the third bit sequence, polar transformation is performed on the first bit sequence and the fourth bit sequence to obtain the fifth bit sequence, and the fifth bit sequence is modulated.

It should be noted that the to-be-encoded bit sequence may also be understood as some to-be-encoded bits.

In the foregoing technical solution, a probability shaping technology is combined with a non-systematic code polar code, modulation and mapping are directly performed on all probability shaped bit sequences, and modulation and mapping are performed on some probability shaped bit sequences together with other bit sequences after polar encoding, so that sub-channel capacity matching is implemented through flexible check, and the transmission rate is maximized.

It should be understood that, with respect to the flexible check described in this application, modulation and mapping are directly performed on all bit sequences obtained through probability shaping, and modulation and mapping are performed on some bit sequences obtained through probability shaping together with other bit sequences after polar encoding. This is equivalent to that some bit sequences obtained through probability shaping are sent twice. A check relationship is formed. Therefore, when a receive end performs demodulation and decoding after receiving the modulation symbol sequence, check may be performed on some bit sequences, thereby reducing a block error rate and increasing the transmission rate.

It should be understood that, for the capacity matching in this application, different bit sequences correspond to different sub-channel capacities, and lengths of information bits that can be sent by a transmit end are also different when polar encoding and modulation are performed on the bit sequence. In this application, polar encoding is performed on some bit sequences obtained through probability shaping and other bit sequences, and then modulation is performed. In this way, during flexible check, for a bit sequence that is sent twice, a bit sequence that is first decoded may be used as a known bit. This is actually equivalent to adding bits to be decoded first and reducing bits to be decoded later. A proper quantity of bits of the foregoing some bit sequences is selected, so that a length of a sent bit sequence matches a sub-channel capacity indicator, thereby improving the transmission rate.

With reference to the first aspect, in some implementations of the first aspect, the third bit sequence obeys specific distribution.

It should be understood that, provided that the third bit sequence can obey the specific distribution, a specific implementation is not limited in this application. The specific distribution may be a Gaussian distribution, a non-uniform binary distribution, or may be another distribution. This is not limited in this application.

With reference to the first aspect, in some implementations of the first aspect, the method further includes: performing polar transformation on the third bit sequence to obtain a sixth bit sequence; and obtaining the fourth bit sequence based on the sixth bit sequence, where a length of the fourth bit sequence is less than that of the sixth bit sequence.

With reference to the first aspect, in some implementations of the first aspect, the fourth bit sequence is obtained based on the sixth bit sequence and based on reliability.

With reference to the first aspect, in some implementations of the first aspect, the obtaining the fourth bit sequence based on the sixth bit sequence includes that: a bit in the fourth bit sequence is a bit with lowest reliability in the sixth bit sequence. With reference to the first aspect, in some implementations of the first aspect, the method further includes: performing polar encoding on the third bit sequence to obtain a sixth bit sequence, where the third bit sequence includes B bit sequences, and the sixth bit sequence includes B bit sequences; and truncating $k\_i$ bits from an $i^{th}$ bit sequence of the sixth bit sequence to form one bit sequence, to obtain the fourth bit sequence, where the fourth bit sequence includes B bit sequences, $i \in [1, B]$, $k\_i$ is a positive integer, $i$ is a positive integer, and B is a positive integer.

With reference to the first aspect, in some implementations of the first aspect, the truncating $k\_i$ bits from an $i^{th}$ bit sequence of the sixth bit sequence to form one bit sequence includes: truncating $k\_i$ bits with lowest reliability from the $i^{th}$ bit sequence in the sixth bit sequence to form one bit sequence. With reference to the first aspect, in some implementations of the first aspect, the fifth bit sequence includes a seventh bit sequence, and the seventh bit sequence is a sequence obtained by performing polar code encoding on one or more sequences in the first bit sequence and on the fourth bit sequence.

With reference to the first aspect, in some implementations of the first aspect, the fifth bit sequence further includes an eighth bit sequence, and the eighth bit sequence is a sequence obtained by performing polar code encoding on a sequence other than the one or more sequences in the first bit sequence.

With reference to the first aspect, in some implementations of the first aspect, the modulating the third bit sequence and the fifth bit sequence includes: modulating a ninth bit sequence and a tenth bit sequence, where the ninth bit sequence and the tenth bit sequence are obtained by performing polar transformation on the third bit sequence and the fifth bit sequence.

It should be understood that the polar transformation mentioned in this application is all bit-by-bit. For example, when polar transformation is performed on a bit sequence, one bit is extracted from the bit sequence to perform polar transformation.

With reference to the first aspect, in some implementations of the first aspect, the modulating the third bit sequence and the fifth bit sequence includes: modulating the third bit sequence and the fifth bit sequence based on a first criterion, where the first criterion includes that bits in the third bit sequence corresponding to first $\dfrac{M}{4}$ and last $\dfrac{M}{4}$ modulation symbols in M modulation symbols arranged from left to right in a constellation diagram are different from bits in the third bit sequence corresponding to remaining modulation symbols, $M = 2^m$, and $m$ is a positive integer greater than or equal to 2. With reference to the first aspect, in some implementations of the first aspect, the first criterion further includes that distances between any two adjacent modulation symbols in a set of modulation symbols corresponding to a same bit in the fifth bit sequence are equal.

It should be understood that, for convenience, a left-to-right arrangement direction is used as an example for description. The left-to-right arrangement herein may alternatively be a right-to-left direction, or may alternatively be a first direction. This is not limited in this application.

With reference to the first aspect, in some implementations of the first aspect, the first criterion further includes that distances between any two adjacent modulation symbols in a set of modulation symbols corresponding to a same bit in the third bit sequence are equal.

With reference to the first aspect, in some implementations of the first aspect, the first criterion further includes that there is only one different bit among a plurality of groups of bits mapped to a same modulation symbol, the one bit corresponds to a bit sequence, and N bits in each group of bits in the plurality of groups of bits correspond to different bit sequences, where the third bit sequence includes B bit sequences, the fifth bit sequence includes A bit sequences, N is determined based on A and B, A is a positive integer, and B is a positive integer.

With reference to the first aspect, in some implementations of the first aspect, the first criterion further includes that there is only one different bit among a plurality of groups of bits mapped to a same modulation symbol, the one bit corresponds to a bit sequence, and N bits in each group of bits in the plurality of groups of bits correspond to different bit sequences, where the third bit sequence includes B bit sequences, the fifth bit sequence includes A bit sequences, N=A+B, A is a positive integer, and B is a positive integer.

It should be understood that during modulation, one bit is selected from each of the foregoing N bit sequences to obtain N bits. For ease of description, the N bits are referred to as a group of bits. However, this is not limited in this application. Herein, "there is only one different bit among a plurality of groups of bits mapped to a same modulation symbol, the one bit corresponds to a bit sequence", as an example, the plurality of groups of bits mapped to the first modulation symbol include a first group of bits and a second group of bits. In addition, both the first group of bits and the second group of bits include N bits, where the N bits are bits corresponding to the first modulation symbol in the modulated N bit sequences, and only one bit is different from the first group of bits and the second group of bits. In addition, the different bit values correspond to a same bit sequence.

It should be understood that "the first criterion includes" and "the mapping criterion includes" in this application may be understood as that the first criterion or the mapping criterion needs to meet the following conditions.

With reference to the first aspect, in some implementations of the first aspect, the first criterion further includes that in the M modulation symbols from left to right in the constellation diagram, a bit in the third bit sequence corresponding to the $i^{th}$ modulation symbol is the same as a bit in the third bit sequence corresponding to the $(M+1-i)^{th}$ modulation symbol, $M= 2^m$, and m is a positive integer greater than or equal to 2.

According to a second aspect, a demodulation and decoding method is provided, including: obtaining a modulation symbol sequence corresponding to a first bit sequence and a second bit sequence, where a quantity of bits included in the first bit sequence is greater than or equal to zero, and a quantity of bits included in the second bit sequence is greater than or equal to zero; demodulating the modulation symbol sequence to obtain a third bit sequence and a fifth bit sequence; decoding the fifth bit sequence to obtain the first bit sequence; and mapping the third bit sequence to obtain the second bit sequence.

In the foregoing technical solution, after the modulation symbol sequence corresponding to the first bit sequence and the second bit sequence are obtained, demodulation and decoding are performed on the modulation symbol sequence, a part of the obtained bit sequences are directly mapped to obtain the second bit sequence, and the other part are continuously decoded to obtain the first bit sequence. The receive end and the transmit end implement sub-channel capacity matching through flexible check to maximize the transmission rate.

With reference to the second aspect, in some implementations of the second aspect, the third bit sequence obeys specific distribution.

With reference to the second aspect, the decoding the fifth bit sequence to obtain the first bit sequence includes: decoding the fifth bit sequence to obtain the first bit sequence and a fourth bit sequence, where the fourth bit sequence is obtained by performing polar transformation on the third bit sequence.

With reference to the second aspect, in some implementations of the second aspect, the demodulating the modulation symbol sequence includes: demodulating the modulation symbol sequence based on a first criterion, where the first criterion includes that bits in the third bit sequence corresponding to first $\dfrac{M}{4}$ and last $\dfrac{M}{4}$ modulation symbols in M modulation symbols arranged from left to right in a constellation diagram are different from bits in the third bit sequence corresponding to remaining modulation symbols, $M= 2^m$, and m is a positive integer greater than or equal to 2.

With reference to the second aspect, in some implementations of the second aspect, the first criterion further includes that distances between any two adjacent modulation symbols in a set of modulation symbols corresponding to a same bit in the fifth bit sequence are equal.

With reference to the second aspect, in some implementations of the second aspect, the first criterion further includes that distances between any two adjacent modulation symbols in a set of modulation symbols corresponding to a same bit in the third bit sequence are equal.

With reference to the second aspect, in some implementations of the second aspect, the first criterion further includes that there is only one different bit among a plurality of groups of bits mapped to a same modulation symbol, the one bit corresponds to a bit sequence, and N bits in each group of bits in the plurality of groups of bits correspond to different bit sequences, where the third bit sequence includes B bit sequences, the fifth bit sequence includes A bit sequences, N is determined based on A and B, A is a positive integer, and B is a positive integer.

With reference to the second aspect, in some implementations of the second aspect, the first criterion further includes that there is only one different bit among a plurality of groups of bits mapped to a same modulation symbol, the one bit corresponds to a bit sequence, and N bits in each group of bits in the plurality of groups of bits correspond to different bit sequences, where the third bit sequence includes B bit sequences, the fifth bit sequence includes A bit sequences, N=A+B, A is a positive integer, and B is a positive integer.

With reference to the second aspect, in some implementations of the second aspect, the first criterion further includes that in the M modulation symbols from left to right in the constellation diagram, a bit in the third bit sequence corresponding to the $i^{th}$ modulation symbol is the same as a bit in the third bit sequence corresponding to the $(M+1-i)^{th}$ modulation symbol, M= $2^m$ , and m is a positive integer greater than or equal to 2.

According to a third aspect, a polar encoding and modulation apparatus is provided, including: a processing unit, configured to group to-be-encoded bit sequences to obtain a first bit sequence and a second bit sequence, where a quantity of bits included in the first bit sequence is greater than or equal to zero, and a quantity of bits included in the second bit sequence is greater than or equal to zero, where the processing unit is configured to map the second bit sequence to obtain a third bit sequence; the processing unit is configured to perform polar transformation on the first bit sequence and a fourth bit sequence to obtain a fifth bit sequence, where the fourth bit sequence is obtained by performing polar transformation on the third bit sequence; and the processing unit is configured to modulate the third bit sequence and the fifth bit sequence to obtain a modulation symbol sequence; and a transceiver unit, configured to send the modulation symbol sequence.

In the foregoing technical solution, a probability shaping technology is combined with a non-systematic code polar code, modulation and mapping are directly performed on all probability shaped bit sequences, and modulation and mapping are performed on some probability shaped bit sequences together with other bit sequences after polar code encoding, so that sub-channel capacity matching is implemented through flexible check, and the transmission rate is maximized.

With reference to the third aspect, in some implementations of the third aspect, the third bit sequence obeys specific distribution.

With reference to the third aspect, in some implementations of the third aspect, the processing unit is further configured to perform polar transformation on the third bit sequence to obtain a sixth bit sequence; and obtain the fourth bit sequence based on the sixth bit sequence, where a length of the fourth bit sequence is less than that of the sixth bit sequence.

With reference to the third aspect, in some implementations of the third aspect, polar encoding is performed on the third bit sequence to obtain a sixth bit sequence, where the third bit sequence includes B bit sequences, and the sixth bit sequence includes B bit sequences; and k_i bits are truncated from an $i^{th}$ bit sequence of the sixth bit sequence to form one bit sequence, to obtain the fourth bit sequence, where the fourth bit sequence includes B bit sequences, $i \in [1, B]$, k_i is a positive integer, i is a positive integer, and B is a positive integer.

With reference to the third aspect, in some implementations of the third aspect, the fifth bit sequence includes a seventh bit sequence, and the seventh bit sequence is a sequence obtained by performing polar code encoding on one or more sequences in the first bit sequence and on the fourth bit sequence.

With reference to the third aspect, in some implementations of the third aspect, the fifth bit sequence further includes an eighth bit sequence, and the eighth bit sequence is a sequence obtained by performing polar code encoding on a sequence other than the one or more sequences in the first bit sequence.

With reference to the third aspect, in some implementations of the third aspect, the modulating the third bit sequence and the fifth bit sequence includes: modulating a ninth bit sequence and a tenth bit sequence, where the ninth bit sequence and the tenth bit sequence are obtained by performing polar transformation on the third bit sequence and the fifth bit sequence.

With reference to the third aspect, in some implementations of the third aspect, the processing unit is further configured to modulate the third bit sequence and the fifth bit sequence based on a first criterion, where the first criterion includes that bits in the third bit sequence corresponding to first $\dfrac{M}{4}$ and last $\dfrac{M}{4}$ modulation symbols in M modulation symbols arranged from left to right in a constellation diagram are different from bits in the third bit sequence corresponding to remaining modulation symbols, M=$2^m$, and m is a positive integer greater than or equal to 2.

With reference to the third aspect, in some implementations of the third aspect, the first criterion further includes that distances between any two adjacent modulation symbols in a set of modulation symbols corresponding to a same bit in the fifth bit sequence are equal.

With reference to the third aspect, in some implementations of the third aspect, the first criterion further includes that distances between any two adjacent modulation symbols in a set of modulation symbols corresponding to a same bit in the third bit sequence are equal.

With reference to the third aspect, in some implementations of the third aspect, the first criterion further includes that there is only one different bit among a plurality of groups of bits mapped to a same modulation symbol, the one bit corresponds to a bit sequence, and N bits in each group of bits in the plurality of groups of bits correspond to different bit sequences, where the third bit sequence includes B bit sequences, the fifth bit sequence includes A bit sequences, N=A+B, A is a positive integer, and B is a positive integer.

With reference to the third aspect, in some implementations of the third aspect, the first criterion further includes that in the M modulation symbols from left to right in the constellation diagram, a bit in the third bit sequence corresponding to the $i^{th}$ modulation symbol is the same as a bit in the third bit sequence corresponding to the $(M+1-i)^{th}$ modulation symbol, $M=2^m$, and m is a positive integer greater than or equal to 2.

According to a fourth aspect, a demodulation and decoding apparatus is provided, including: a transceiver unit, configured to obtain a modulation symbol sequence corresponding to a first bit sequence and a second bit sequence, where a quantity of bits included in the first bit sequence is greater than or equal to zero, and a quantity of bits included in the second bit sequence is greater than or equal to zero; and a processing unit, configured to demodulate the modulation symbol sequence to obtain a third bit sequence and a fifth bit sequence, where the processing unit is configured to decode the fifth bit sequence to obtain the first bit sequence; and the processing unit is configured to map the third bit sequence to obtain the second bit sequence.

In the foregoing technical solution, after the modulation symbol sequence corresponding to the first bit sequence and the second bit sequence are obtained, demodulation and decoding are performed on the modulation symbol sequence, a part of the obtained bit sequences are directly mapped to obtain the second bit sequence, and the other part are continuously decoded to obtain the first bit sequence. The receive end and the transmit end implement sub-channel capacity matching through flexible check to maximize the transmission rate.

With reference to the fourth aspect, in some implementations of the fourth aspect, the third bit sequence obeys specific distribution.

With reference to the fourth aspect, the processing unit is further specifically configured to decode the fifth bit sequence to obtain the first bit sequence and a fourth bit sequence, where the fourth bit sequence is obtained by performing polar transformation on the third bit sequence.

With reference to the fourth aspect, in some implementations of the fourth aspect, the processing unit is further specifically configured to modulate the third bit sequence and the fifth bit sequence based on a first criterion, where the first criterion includes that bits in the third bit sequence corresponding to first $\dfrac{M}{4}$ and last $\dfrac{M}{4}$ modulation symbols in M modulation symbols arranged from left to right in a constellation diagram are different from bits in the third bit sequence corresponding to remaining modulation symbols, $M=2^m$, and m is a positive integer greater than or equal to 2.

With reference to the fourth aspect, in some implementations of the fourth aspect, the first criterion further includes that distances between any two adjacent modulation symbols in a set of modulation symbols corresponding to a same bit in the fifth bit sequence are equal.

With reference to the fourth aspect, in some implementations of the fourth aspect, the first criterion further includes that distances between any two adjacent modulation symbols in a set of modulation symbols corresponding to a same bit in the third bit sequence are equal.

With reference to the fourth aspect, in some implementations of the fourth aspect, the first criterion further includes that there is only one different bit among a plurality of groups of bits mapped to a same modulation symbol, the one bit corresponds to a bit sequence, and N bits in each group of bits in the plurality of groups of bits correspond to different bit sequences, where the third bit sequence includes B bit sequences, the fifth bit sequence includes A bit sequences, N=A+B, A is a positive integer, and B is a positive integer.

With reference to the fourth aspect, in some implementations of the fourth aspect, the first criterion further includes that in the M modulation symbols from left to right in the constellation diagram, a bit in the third bit sequence corresponding to the $i^{th}$ modulation symbol is the same as a bit in the third bit sequence corresponding to the $(M+1-i)^{th}$ modulation symbol, $M=2^m$, and m is a positive integer greater than or equal to 2.

According to a fifth aspect, a communication apparatus is provided, including: a processor and a memory, where the memory is configured to store a computer program; and the processor is configured to execute the computer program stored in the memory, so that the communication apparatus performs the communication method and embodiments according to any one of the first aspect and the second aspect.

According to a sixth aspect, a computer-readable storage medium is provided, where the computer-readable storage medium stores instructions, and when the computer instructions are run on a computer, the computer is enabled to perform the communication method and embodiments according to any one of the first aspect and the second aspect.

According to a seventh aspect, a chip is provided, including: a memory, configured to store a computer program; and a processor, configured to read and execute the computer program stored in the memory, and when the computer program is executed, the processor performs the communication method and embodiments according to any one of the first aspect and the second aspect.

According to an eighth aspect, a computer program product is provided, where the computer program product includes computer program code, and when the computer program code is run on a computer, the computer is enabled to perform the communication method and embodiments according to any one of the first aspect and the second aspect.

## BRIEF DESCRIPTION OF DRAWINGS

FIG. 1 is a diagram of an architecture of a wireless communication system 100 applicable to an embodiment of this application.

FIG. 2 is a basic flowchart of communication performed by using a wireless technology.

FIG. 3 is a schematic diagram of polar polar code encoding.

FIG. 4 is a schematic flowchart of a polar encoding and modulation method according to an embodiment of this application.

FIG. 5 is a schematic flowchart of a demodulation and decoding method according to an embodiment of this application.

FIG. 6 is a schematic flowchart of a polar encoding and modulation method according to an embodiment of this application.

FIG. 7 is a performance comparison diagram of a method 600 and MLC modulation in this application in a case in which a modulation order is 64QAM.

FIG. 8 is a schematic flowchart of a polar encoding and modulation method according to an embodiment of this application.

FIG. 9 is a performance comparison diagram of a method 1000 and BICM modulation in this application in a case in which a modulation order is 64QAM.

FIG. 10 is a schematic block diagram of a polar encoding and modulation apparatus or a demodulation and decoding apparatus according to this application.

FIG. 11 is a schematic diagram of a structure of a communication device 20 according to this application.

FIG. 12 is a schematic diagram of an internal structure of a processing apparatus 21 according to this application.

FIG. 13 is a schematic diagram of a structure of a communication apparatus according to this application.

FIG. 14 is a schematic diagram of a structure of a terminal device 7000 according to this application.

## DESCRIPTION OF EMBODIMENTS

The following describes technical solutions of this application with reference to accompanying drawings.

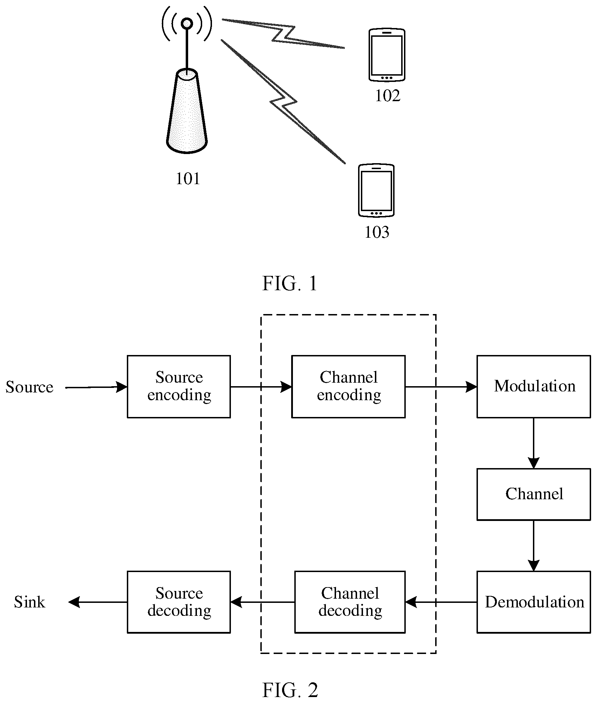

Refer to FIG. 1. FIG. 1 is a diagram of an architecture of a wireless communication system 100 applicable to an embodiment of this application. As shown in FIG. 1. The wireless communication system 100 may include at least one network device and one or more terminal devices. The network device (101 shown in FIG. 1) may perform wireless communication with the one or more terminal devices (102 and 103 shown in FIG. 1).

The wireless communication system in this application includes, but is not limited to, a global system of mobile communication (global system of mobile communication, GSM) system, a code division multiple access (code division multiple access, CDMA) system, a wideband code division multiple access (wideband code division multiple access, WCDMA) system, a general packet radio service (general packet radio service, GPRS), a long term evolution (long term evolution, LTE) system, an LTE frequency division duplex (frequency division duplex, FDD) system, an LTE time division duplex (time division duplex, TDD), a universal mobile telecommunication system (universal mobile telecommunication system, UMTS), a worldwide interoperability for microwave access (worldwide interoperability for microwave access, WiMAX) communication system, and three major application scenarios of a next-generation 5G mobile communication system, that is, enhanced mobile broadband (enhance mobile broadband, eMBB), an ultra reliable low latency communication (ultra reliable low latency communication, URLLC), and an enhanced massive machine type communication (massive machine type communication, eMTC), or future new communication systems.

The terminal device in embodiments of this application may be user equipment (user equipment, UE), a terminal (terminal), an access terminal, a subscriber unit, a subscriber station, a mobile station, a mobile console, a remote station, a remote terminal, a mobile device, a user terminal, a terminal, a wireless communication device, a user agent, or a user apparatus. The terminal device may be a cellular phone, a cordless phone, a session initiation protocol (session initiation protocol, SIP) phone, a wireless local loop (wireless local loop, WLL) station, a personal digital assistant (personal digital assistant, PDA), a handheld device and a computing device both having a wireless communication function, another processing device connected to a wireless modem, a vehicle-mounted device, a wearable device, a terminal device in a future 5G network, or a terminal device in a future evolved public land mobile network (public land mobile network, PLMN), and the like. This is not limited in this application.

The network device in this application may be a device configured to communicate with a terminal device. The network device may be a base station, or may be a device obtained by integrating a base station and a base station controller, or may be another device with a similar communication function. The base station described herein may be a base transceiver station (base transceiver station, BTS) in a global system of mobile communication (global system of mobile communication, GSM) system or a code division multiple access (code division multiple access, CDMA), or may be a nodeB (nodeB, NB) in a wideband code division multiple access (wideband code division multiple access, WCDMA) system, or may be an evolved NodeB (evolved nodeB, eNB or eNodeB) in a long term evolution (long term evolution, LTE) system, or may be a radio controller in a cloud radio access network (cloud radio access network, CRAN) scenario. Alternatively, the network device may be a relay station, an access point, an in-vehicle device, a wearable device, a network device in a future 3rd generation partnership project (3rd generation partnership project, 3GPP) network, or the like. This is not limited in embodiments of this application.

The network device in FIG. 1 communicates with the terminal device by using a wireless technology. When the network device sends a signal, the network device is a transmit end, and when the network device receives a signal, the network device is a receive end. The terminal device is also the same. When the terminal device sends a signal, the terminal device is a transmit end, and when the terminal device receives a signal, the terminal device is a receive end.

FIG. 2 is a basic flowchart of communication performed by using a wireless technology. After source encoding, channel encoding, rate matching, and modulation are performed, a signal source at the transmit end is sent on the channel. After receiving the signal, the receive end performs demodulation, rate de-matching, channel decoding, and source decoding to obtain a sink.

Channel encoding/decoding is one of the core technologies in the field of wireless communication, and the improvement of its performance will directly improve network coverage and a user transmission rate. Currently, a polar code (Polar code) is a channel coding technology that can be theoretically proved to reach a Shannon limit and has a practical linear complexity coding and decoding capability. A polar code is a linear block code, and a coding matrix (also referred to as a generator matrix) of the polar code is $F_N$. An encoding process may be represented by using the following formula:

$$x_1^N = \mu_1^N \cdot F_N \qquad (1)$$

where $\mu_1^N = (\mu_1, \mu_2, ..., \mu_N)$ is a binary row vector (that is, an information bit sequence), and a length thereof is N, where $N=2^n$, and n is a positive integer. $F_N$ is an N×N matrix, $F_N = F_2^{\otimes(\log_2 N)}$. $F_2^{\otimes(\log_2 N)}$ is defined as a Kronecker (Kronecker) product of log2^N matrices $F_2$, and $F_2 = \begin{bmatrix} 1 & 0 \\ 1 & 1 \end{bmatrix}$. The addition and multiplication operations involved in the above are all addition and multiplication operations on the binary Galois domain.

For codes generated by using this method, a polarization phenomenon occurs by using a successive cancellation (successive cancellation, SC) decoding method. That is, some bits in u pass through an equivalent high-reliability channel and are translated with a high probability, and the remaining bits pass through an equivalent low-reliability channel and are translated with a low probability. Therefore, the highly-reliable channel may be used for information transmission, and a bit corresponding to the low-reliable channel is set to zero (that is, frozen), and is not used for data transmission, or for transmitting data known by both communication parties.

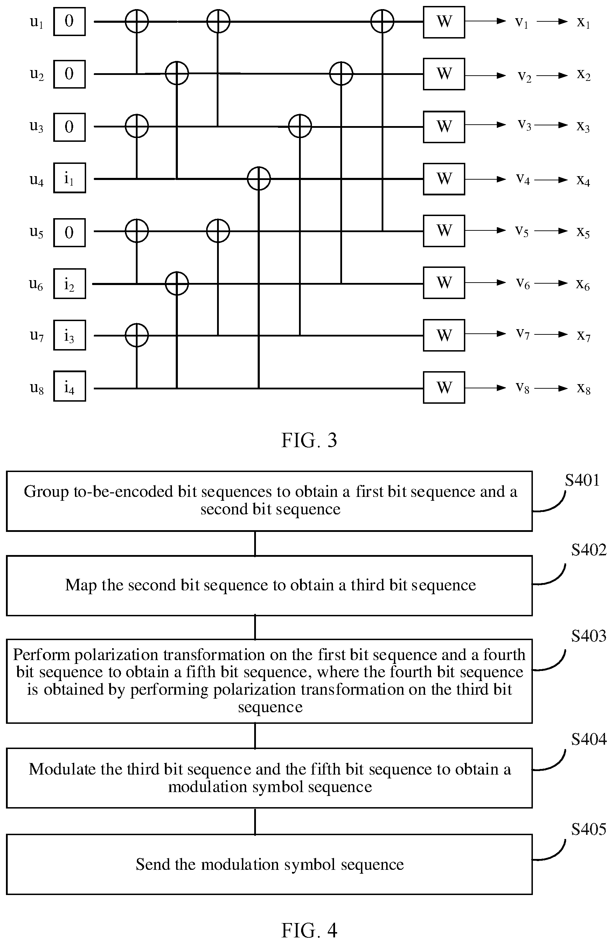

Refer to FIG. 3. FIG. 3 is a schematic diagram of polar polar code encoding. As shown in FIG. 3, the symbol "⊕" represents binary addition, the input thereof is at a left side and a lower side, and the output thereof is at a right side. Each solid line in FIG. 3 represents 1 bit. {$u_1$, $u_2$, $u_3$, $u_5$} are set as frozen bits, and polar encoding is performed on total four information bits in {$u_4$, $u_6$, $u_7$, $u_8$} to obtain eight encoded bits. After encoding, the 8-bit encoded bits are modulated and sent through a noise channel.

The to-be-encoded bits are sorted based on their respective reliability. Generally, a bit with higher reliability is set to an information bit (data), a bit with lower reliability is set to a fixed bit (frozen), and a value of the fixed bit (frozen) is usually set to 0. In an actual transmission, both the transmit end and the receive end are known. As shown in FIG. 1, $u_7$, $u_6$, $u_5$, and $u_3$ are top four bits of reliability, and are set as information bits (data), and $u_4$, $u_2$, $u_1$ and $u_0$ are last four bits of reliability, and are set as fixed bits (frozen).

A mainstream polar code decoding method is mainly polar code time sequence decoding. polar code time sequence decoding means that a decoder performs decoding bit-by-bit based on a natural time sequence of a polar design. Currently, major polar code time sequence decoding algorithm includes SC (successive cancellation) decoding, SCL (successive cancellation list) decoding, CA-SCL (CRC-aided successive cancellation list) decoding, and the like. In terms of decoding performance, SC decoding is the worst. Compared with the former, SCL decoding is greatly improved. In addition, CA-SCL after CRC check can make performance of a polar code better than an LDPC code and a Turbo code. Therefore, SCL decoding and CA-SCL decoding are mainly used in an actual system.

To better describe this solution, the following describes some technical concepts involved in this application.

In recent years, as a polar code is listed in a wireless communication 5G standard, design of a polar code modulation scheme has also become a hot issue in a communication direction. Through modulation, a binary polar code codeword bit is mapped into a real-number symbol, and then sent to a receiver by using a channel.

To further improve spectral efficiency, a high-order modulation technology can be used to map a plurality of codeword bits to a same channel symbol. In a high-order modulation, energy of different symbols is different. By using a current shaping, more low-energy symbols can be sent and fewer high-energy symbols can be sent, thereby saving average energy. Theoretical analysis shows that for Gaussian white noise channel, mutual information transmitted per unit energy is the largest when the signal distribution sent obeys Gaussian distribution. Compared with the uniform distribution, the Gaussian distribution has the best performance. Theoretically, the performance gain is 1.53 dB.

Currently, there are the following two specific implementation methods to achieve the foregoing objectives:

(1) Geometric shaping. Geometric shaping keeps the equal distribution of input symbols, but makes special design for constellation points. Low energy constellation points are denser, and high energy constellation points are sparser.
(2) Probability shaping. Probability shaping keeps constellation distribution unchanged, and adjusts the probability of constellation points. The probability of symbols with low energy is higher, and the probability of symbols with high energy is lower.

Relatively speaking, probability shaping does not need to change the existing constellation, and is simple to implement.

However, in the high-order modulation scenario, even if a relatively simple probability shaping technology is combined with a polar code, problems such as incompatibility, high complexity, and limited flexibility exist.

This application mainly proposes a solution of combining a polar code with a higher-order modulation technology, to resolve the foregoing problem.

The following describes in detail a polar encoding and modulation method 400 in an embodiment of this application with reference to FIG. 4. FIG. 4 is a schematic flowchart of a method 400 according to this application. The method 400 may be performed by a transmit end. For example, in the communication system shown in FIG. 1, uplink transmission is performed by a terminal device. Downlink transmission is performed by a network device (for example, a base station). The method 400 is described below.

S401. Group to-be-encoded bit sequences to obtain a first bit sequence and a second bit sequence.

It should be understood that a quantity of bits included in the first bit sequence is greater than or equal to zero, and a quantity of bits included in the second bit sequence is greater than or equal to zero.

In an example, the to-be-encoded bit sequence may be divided into N groups based on a modulation order $2^N$, to obtain a first bit sequence and a second bit sequence, where the first bit sequence includes n1 bit sequences, and the second bit sequence includes n2 bit sequences. n1+n2=N, where N, n1, and n2 are positive integers.

S402. Map the second bit sequence to obtain a third bit sequence.

Through mapping, the obtained third bit sequence may obey specific distribution.

In an example, the second bit sequence includes n2 bit sequences, and the obtained third bit sequence also includes n2 bit sequences, where n2 is a positive integer.

It should be understood that, in the solution in this application, the second bit sequence is separately processed, and the second bit sequence is not obtained based on the first bit sequence.

S403. Perform polar transformation on the first bit sequence and a fourth bit sequence to obtain a fifth bit sequence, where the fourth bit sequence is obtained by performing polar transformation on the third bit sequence.

In an example, the first bit sequence includes n1 bit sequences, the third bit sequence includes n2 bit sequences, and the fourth bit sequence includes n2 sequences. When polar transformation is performed on the first bit sequence and the fourth bit sequence, polar transformation may be performed together on one or more sequences in the first bit sequence and on the fourth bit sequence, and polar transformation is separately performed on other bit sequences in the first bit sequence.

It should be understood that, after polar transformation is performed on the third bit sequence, other processing may be performed to obtain the fourth bit sequence. For example, the sixth bit sequence may be obtained by performing polar transformation on the third bit sequence, and a part of the sequence is extracted from the sixth bit sequence as the fourth bit sequence.

With regard to extracting the fourth bit sequence from the sixth bit sequence, for example, the sixth bit sequence includes n3 bit sequences, and a bit with lowest reliability is extracted from each sequence in the sixth bit sequence to form a bit sequence, and the bit sequence is used as a bit sequence in the fourth bit sequence. Therefore, there are also n3 bit sequences in the fourth bit sequence.

S404. Modulate the third bit sequence and the fifth bit sequence to obtain a modulation symbol sequence.

In an example, the third bit sequence and the fifth bit sequence are separately modulated.

In an example, before the third bit sequence and the fifth bit sequence are modulated, interleaving may further be performed on the third bit sequence and the fifth bit sequence. Specifically, one or more bit sequences in the third bit sequence may be separately interleaved, or one or more bit sequences in the fifth bit sequence may be separately interleaved.

Specifically, to combine polar code encoding with a higher-order modulation technology, a modulation process in this application needs to meet some mapping criteria, to obtain a higher transmission rate. For specific criteria, refer to criterion 1 to criterion 4 in a method 600 and a method 700.

S405. Send the modulation symbol sequence.

In this embodiment of this application, a probability shaping technology is combined with a non-systematic code polar code, modulation and mapping are directly performed on all probability shaped bit sequences, and modulation and mapping are performed on some probability shaped bit sequences together with other bit sequences after polar code encoding, so that sub-channel capacity matching is implemented through flexible check, and the transmission rate is maximized.

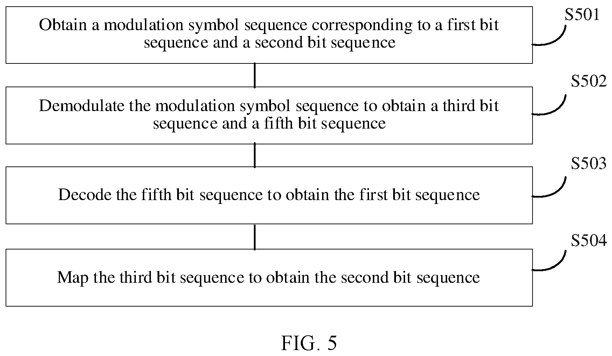

The following describes in detail a demodulation and decoding method 500 in an embodiment of this application with reference to FIG. 5. FIG. 5 is a schematic flowchart of a method 500 according to this application. The method 500 may be performed by a receive end. For example, in the communication system shown in FIG. 1, downlink transmission is performed by a terminal device. Uplink transmission is performed by a network device (for example, a base station). The method 500 is described below.

S501. Obtain a modulation symbol sequence corresponding to a first bit sequence and a second bit sequence.

In an example, the receive end receives a modulation symbol sequence from the transmit end.

S502. Demodulate the modulation symbol sequence to obtain a third bit sequence and a fifth bit sequence.

The demodulation process also needs to meet the same mapping criteria as those in the modulation process.

S503. Decode the fifth bit sequence to obtain the first bit sequence.

S504. Map the third bit sequence to obtain the second bit sequence.

In this embodiment of this application, after the modulation symbol sequence corresponding to the first bit sequence and the second bit sequence are obtained, demodulation and decoding are performed on the modulation symbol sequence, a part of the obtained bit sequences are directly mapped to obtain the second bit sequence, and the other part are continuously decoded to obtain the first bit sequence. The receive end and the transmit end implement sub-channel capacity matching through flexible check to maximize the transmission rate.

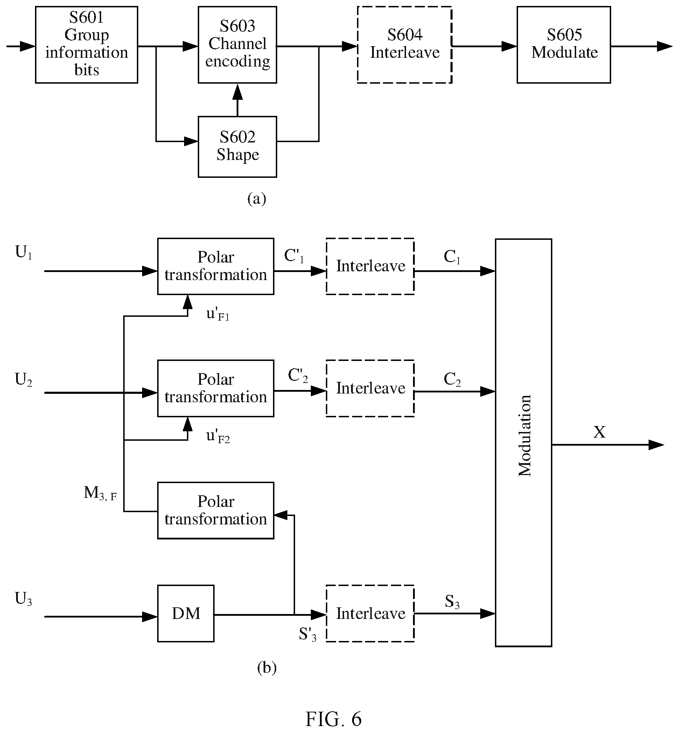

The following describes in detail a polar encoding and modulation method 600 in an embodiment of this application with reference to FIG. 6. FIG. 6 is a schematic flowchart of a method 600 according to this application.

(a) in FIG. 6 shows a general procedure of the method 600. For ease of description, a technical solution of this application is applied to a multi-level coding (multi-level coding, MLC) modulation technology, and 8ASK/64QAM is used as an example for description. This is further described with reference to the embodiment shown in (b) in FIG. 6. It should be noted that (b) in FIG. 6 is merely a possible embodiment of implementing the method 600. This is not limited in this application. The method in this application may also be applied to another modulation technology. For convenience, MLC is used as an example for description in this embodiment, but this is not limited. The method in this application may also be applied to another high-order modulation order. For convenience, 8ASK/64QAM is used as an example for description in this application, but this is not limited.

S601. Group information bits.

The to-be-encoded bit sequence whose length is K is divided into three groups, which are denoted as $U_1=u_1, u_2,...u_{k1}$, $U_2=u_{k1+1}, u_{k1+2},...u_{k2}$, and $U_3=u_{k2+1}, u_{k2+2},...u_K$.

For ease of describing the technical solutions in this embodiment, $U_1$ and $U_2$ are referred to as encoded bit sequences, and $U_3$ is referred to as a shaped bit sequence. However, this is not limited in this application.

It should be understood that, in an example, how many groups are divided into may be determined based on a modulation order, and a quantity of bits in each group is determined based on a bit level of a modulation scheme. Specific implementation is based on an algorithm.

It should be noted that for convenience, in this embodiment, an example in which the to-be-encoded bit sequence is divided into three groups is used for description. There may be another implementation in specific implementation of this technical solution. This is not limited in this application.

S602. Shape.

The sequence $U_3$ is mapped by using a distribution matching (distribution matching, DM) to obtain

$$S_3' = s_{3,1}', ..., s_{3,N}'$$ , and a sequence length of $S_3'$ is N.

It should be understood that, by using the DM, a binary bit sequence that is evenly distributed may be mapped to a bit sequence or a symbol sequence that obeys specific distribution. A common DM may use a method such as constant composition distribution matching (constant composition distribution matching, CCDM), enumerative sphere shaping (enumerative sphere shaping, ESS), and the like.

S603. Channel encoding.

$M_3 = m_{3,1}, ..., m_{3,N}$ is obtained by performing polar transformation on $S_3'$, a sequence $M_{3,F} = \{m_{3,i}, i \in F\}$ is extracted from $M_3$, and polar channel encoding is performed on $M_{3,F}$, $U_1$, and $U_2$, to obtain $C_1' = c_{1,1}', ..., c_{1,N}'$, and

$$C_2' = c_{2,1}', ..., c_{2,N}' \ .$$

In an example, a bit with lowest reliability in $M_3$ are extracted to form a sequence $M_{3,F}$. The F here is a collection.

It should be noted that there are a plurality of implementations for performing polar channel encoding on $M_{3,F}$, and $U_1$ and $U_2$ .

For example, polar code encoding may be performed on $M_{3,F}$ with $U_1$ or $U_2$, or polar code encoding may be performed on $M_{3,F}$ with $U_1$ or $U_2$. This is not limited in this embodiment.

In an example, as shown in (b) in FIG. 6, polar code encoding is performed on $u_{F1}'$ which is a part of $M_{3,F}$ and together with $U_1$, a remaining part of $M_{3,F}$ is $u_{F2}'$ , and polar code encoding is performed on $u_{F2}'$ together with $U_2$.

Alternatively, in an example, polar code encoding is performed on $M_{3,F}$ together with $U_1$, and polar code encoding is performed separately on $U_2$. This is not limited in this application.

S604. Interleave.

Intra-block interleaving is performed on $S_3'$ , $C_1'$ , and $C_2'$ to obtain $S_3$, $C_1$, and $C_2$.

It should be understood that the intra-block interleaving herein is separately performed on $S_3'$ , separately performed on $C_1'$ , and separately performed on $C_2'$ .

It should be noted that this step is optional. As shown in (b) in FIG. 6, intra-block interleaving may be performed on one or more of $S_3'$ , $C_1'$ , and $C_2'$ , or no interleaving may be performed. This is not limited in this embodiment of this application.

S605. Modulate and map.

$C_1$, $C_2$, and $S_3$ are mapped to an 8ASK modulation symbol, denoted as $X$. $c_{1,i}$, $c_{2,i}$, and $s_{3,i}$ are mapped to $x_i$. $X = \{x_1, ..., x_N\}$.

Further, $C_1$, $C_2$, and $S_3$ are mapped based on a mapping criterion.

For convenience, Table 1 is used as an example to describe the external features that need to be met in the mapping criterion. The mapping criterion may also have a plurality of other possible implementations, which is not limited in this embodiment.

It should be understood that the first row in Table 1 is modulation symbols in the constellation diagram from left to right corresponding to a case in which the modulation order is 8ASK. The first column is $c_{1,i}$, $c_{2,i}$, and $s_{3,i}$, which are bits selected from $C_1$, $C_2$, and $S_3$ respectively. During mapping, after the bits $c_{1,i}$, $c_{2,i}$, and $s_{3,i}$ are extracted from $C_1$, $C_2$, and $S_3$, based on the mapping criterion, the bits are determined to be mapped to $x_i$. For example, one bit 0 is extracted from $C_1$, one bit 1 is extracted from $C_2$, and one bit 1 is extracted from $S_3$, and based on the mapping criterion, the bits are determined to be mapped to -7.

As shown in Table 1, the mapping criterion satisfies the criterion 1: For any sequence in $C_1$, $C_2$, and $S_3$, distances between any two adjacent modulation symbols in a set of modulation symbols corresponding to a same bit in the sequence are equal in the constellation diagram.

In an example, when a modulation symbol subset is selected from the given $c_{1,i}$ and/or $c_{2,i}$, a distance, in the constellation map, between the modulation symbols in the modulation symbol subset is independent of a preamble bit. For example, when one bit in $C_1$ is given as 0, or $c_{1,i}$=0, a selected symbol subset is {-7, -3, 1, 5}, or when one bit in $C_1$ is given as 1, or $c_{2,i}$=1, a selected symbol subset is {-5, -1, 3, 7}. It can be learned that a nearest distance between two symbols is equal to 4 in both cases. For example, in a similar manner, it may also be deduced that, regardless of whether the given bit in $C_1$ or $C_2$ is 0 or 1, a nearest distance between two symbols in the selected symbol subset is 8.

It should be understood that the nearest distance between two symbols in the selected modulation symbol subset is equal, so that probability of bit errors is almost equal in a transmission process. When this technical solution is combined with this technical solution, a block error rate can be reduced, and a transmission rate can be improved.

As shown in Table 1, the mapping criterion satisfies the criterion 2: In bits in $S_3$ corresponding to modulation symbols from left to right in the constellation diagram, bits corresponding to a first quarter of modulation symbols and a last quarter of modulation symbols are different from bits corresponding to a middle half of modulation symbols. For example, in Table 1, $s_{3,i}$ corresponding to modulation symbols from left to right in the constellation diagram is [1 1 0 0 0 0 1 1], and four symbols in the middle are different from four symbols on both sides.

It should be understood that, when the mapping criterion satisfies the criterion 2, a final symbol distribution may be closer to a Gaussian distribution, so that an amount of mutual information transmitted per unit energy is larger, a block error rate is reduced, and a transmission rate is improved.

**Table 1**

|         | -7 | -5 | -3 | -1 | 1 | 3 | 5 | 7 |
|---------|----|----|----|----|---|---|---|---|
| $c_{1,i}$ | 0  | 1  | 0  | 1  | 0 | 1 | 0 | 1 |
| $c_{2,i}$ | 1  | 1  | 0  | 0  | 1 | 1 | 0 | 0 |
| $s_{3,i}$ | 1  | 1  | 0  | 0  | 0 | 0 | 1 | 1 |

It should be noted that for convenience, in this embodiment, there is only one shaped bit sequence, that is, only one of the bit sequences ($U_3$) is used as an example for description. When this technical solution is implemented, a probability shaping technology may be further used for a plurality of bit sequences. This is not limited in this application.

For example, when the modulation order is 8ASK, probability shaping may be performed on at most two bit sequences at the same time. When the modulation order is 16ASK, probability shaping may be performed on at most three bits at the same time.

The following provides some supplementary descriptions based on the foregoing embodiment for the probability shaping solution of the plurality of bit sequences.

In S602, when probability shaping is performed on the plurality of bits, there are a plurality of possible implementations, including but not limited to the following two possible implementations:

In a possible manner 1, each bit sequence is mapped by using a single-bit DM, to obtain a bit sequence that obeys specific distribution.

In a possible manner 2, mapping is performed on a plurality of bit sequences by sharing a plurality of bit DMs, to obtain a bit sequence that obeys specific distribution.

In an example, there are a plurality of possible implementations for performing probability shaping on the two bit sequences $S_1$ and $S_2$, including but not limited to the following two possible implementations.

In a possible manner 1, mapping is performed on $S_1$ and $S_2$ by using a single-bit DM, to obtain a bit sequence that obeys specific distribution.

In a possible manner 2, mapping is performed on $S_1$ and $S_2$ by sharing two bits DMs, to obtain a bit sequence that obeys specific distribution. For example, the two bits may be 0, 1, 2, or 3.

It should be understood that probability shaping is implemented in a multi-bit DM mapping manner, so that probability distribution of symbols can be adjusted more accurately, so that symbols obtained by mapping are closer to Gaussian distribution.

In S603, in an example, when probability shaping is performed on two bit sequences $S_1$ and $S_2$, $M_{3,F}$ may be a set of bits with lowest reliability extracted from $S'_1$ and $S'_2$.

In S605, in addition to meeting the foregoing criterion 1 and the foregoing criterion 2, the foregoing mapping criterion further needs to meet the criterion 3: In a bit sequence that is finally output after a series of processing is performed on the shaped bit sequence, modulation symbols corresponding to a same group of bits meet symmetry in the constellation diagram.

It should be understood that the first row in Table 2 is modulation symbols in the constellation diagram from left to right corresponding to a case in which the modulation order is 8ASK. The first column is $c_{1,i}$, $s_{2,i}$, and $s_{3,i}$, which are bits selected from $C_1$, $S_2$, and $S_3$ respectively. During mapping, after the bits $c_{1,i}$, $s_{2,i}$, and $s_{3,i}$ are extracted from $C_1$, $S_2$, and $S_3$, based on the mapping criterion, the bits are determined to be mapped to $x_i$. For example, one bit 0 is extracted from $C_1$, one bit 0 is extracted from $S_2$, and one bit 1 is extracted from $S_3$, and based on the mapping criterion, the bits are determined to be mapped to -7.

For example, Table 2 is a possible mapping criterion that meets the foregoing criteria 1, 2, and 3. As shown in Table 2, when $s_{2,i}=0$, and $s_{3,i}=1$, modulation symbols mapped to them are -7 and 7, and when $s_{2,i}=1$, and $s_{3,i}=1$, modulation symbols mapped to them are -5 and 5. Because $c_{1,i}$ obeys uniform distribution, in this method, the probability distribution of modulation symbols can be symmetric Gaussian distribution, and the transmission rate can be further improved.

**Table 2**

|          | -7 | -5 | -3 | -1 | 1 | 3 | 5 | 7 |
|----------|----|----|----|----|---|---|---|---|
| $c_{1,i}$ | 0  | 1  | 0  | 1  | 0 | 1 | 0 | 1 |
| $s_{2,i}$ | 0  | 1  | 1  | 0  | 0 | 1 | 1 | 0 |
| $s_{3,i}$ | 1  | 1  | 0  | 0  | 0 | 0 | 1 | 1 |

In this embodiment of this application, a probability shaping technology is combined with a non-systematic code polar code, modulation and mapping are directly performed on all probability shaped bit sequences, and modulation and mapping are performed on some probability shaped bit sequences together with other bit sequences after polar code encoding, so that sub-channel capacity matching is implemented through flexible check, and the transmission rate is maximized. Further, compared with an existing MLC modulation scheme, the polar encoding and modulation method 600 provided in this application can maximize a transmission rate, and a large quantity of experimental results show that the polar encoding and modulation method 600 has a general performance gain compared with an existing MLC modulation scheme.

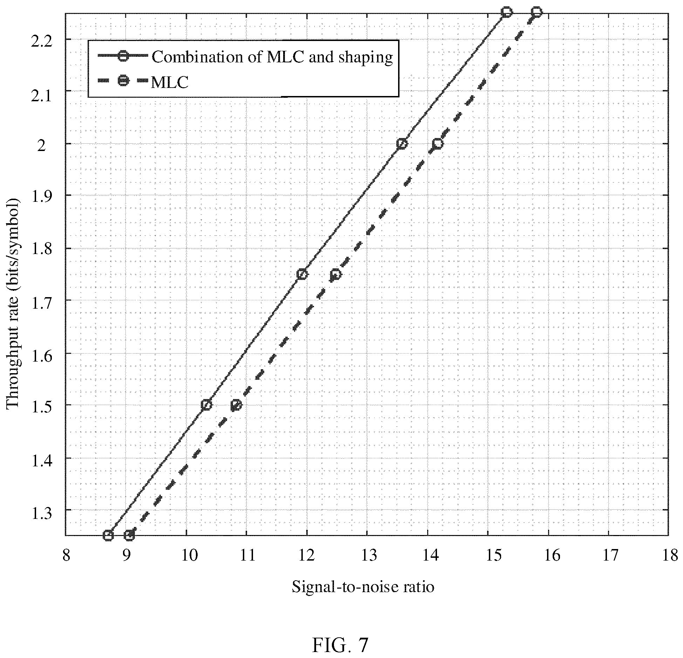

The following provides a performance comparison diagram between a method 600 in this application and an existing MLC modulation scheme. In FIG. 7, MLC represents a multi-layer encoding and modulation technology, and a curve corresponding to MLC represents that modulation is performed by using polar encoding and the MLC modulation technology. A curve corresponding to "MLC combination shaping" represents that the polar encoding and modulation method provided in this application is used, polar encoding is combined with a probability shaping technology, and modulation is performed by using the MLC modulation technology. The vertical coordinate is a current throughput (throughput) rate, unit is bits per symbol (bits per symbol), and the horizontal coordinate is a signal-to-noise ratio required for a block error rate (block error rate, BLER) to reach $1\ e^{-2}$. Alternatively, it may be understood as a ratio of symbol energy to noise power spectral density (ratio of symbol energy to noise power spectral density, EsN0) of the noise required for the block error rate to reach $1\ e^{-2}$. It should be understood that, in the following figure, a leftward curve represents better performance. In other words, in a case in which signal-to-noise ratios are the same, a higher current throughput rate represents a higher transmission rate and better performance.

Refer to FIG. 7. FIG. 7 is a performance comparison diagram of a method 600 and MLC modulation in this application in a case in which BLER=0.01 and a modulation order is 64QAM.

It can be learned that the solution in this embodiment of this application has a general performance gain compared with a baseline solution.

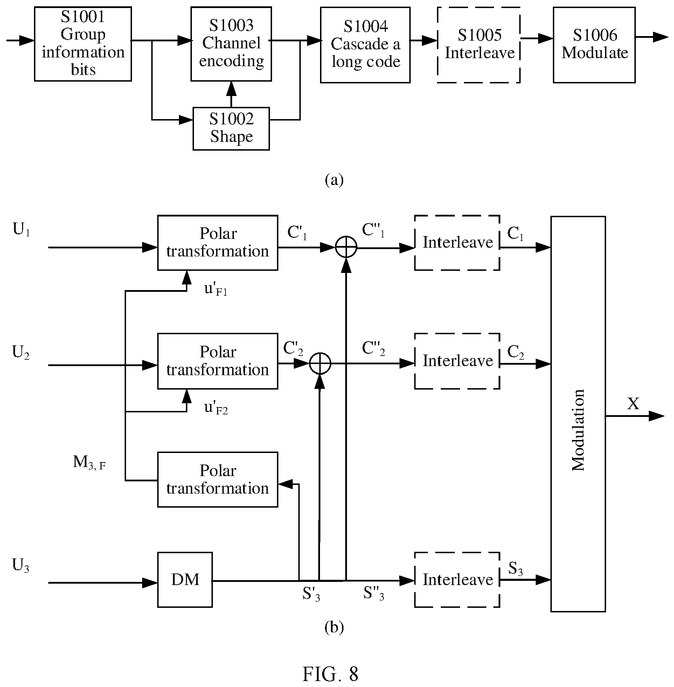

The following describes in detail a polar encoding and modulation method 1000 in an embodiment of this application with reference to FIG. 8. FIG. 8 is a schematic flowchart of a method 1000 according to this application.

(a) in FIG. 8 shows a general procedure of the method 1000. For ease of description, the technical solutions of this application are applied to a bit interleaved coded modulation (bit interleaved coded modulation, BICM) technology, and 8ASK/64QAM is used as an example for description. This is further described with reference to the embodiment shown in (b) in FIG. 8. It should be noted that (b) in FIG. 8 is merely a possible embodiment of implementing the method 1000. This is not limited in this application. The method in this application may also be applied to another modulation technology. For convenience, BICM is used as an example for description in this embodiment, but this is not limited. The method in this application may also be applied to another random-order modulation order. For convenience, 8ASK/64QAM is used as an example for description in this application, but this is not limited.

S1001. Group information bits. S1001 is roughly the same as step S601 in the method 600. However, in a specific implementation, corresponding algorithms are also different due to different modulation orders and modulation schemes.

S1002. Shape. S1002 is roughly the same as step S602 in the method 600.

S1003. Channel encoding. S1003 is roughly the same as step S603 in the method 600.

S1004. Cascade a long code.

Cascade $S_3'$, $C_1'$, and $C_2'$ as long codes to obtain $S_3''$, $C_1''$, and $C_2''$, where polar code encoding is performed on $c'_{1,i}$, $c'_{2,i}$, and $s'_{3,i}$ to obtain $c''_{1,i}$, $c''_{2,i}$, and $s''_{3,i}$.

For example, in this step, polar encoding is performed on every three bits, and a length is not a power of 2. For a bit sequence that is not a mother code length, the last bit may be set to 0 in a natural order from back to front.

For example, as shown in (b) in FIG. 8, cascaded $C_1'' = C_1' + S_3'$, cascaded $C_2'' = C_2' + S_3'$, and cascaded $S_3'' = S_3'$.

S1005. Interleave.

Intra-block interleaving is performed on $S_3^{''}$, $C_1^{''}$, and $C_2^{''}$ to obtain $S_3$, $C_1$, and $C_2$.

It should be understood that the intra-block interleaving herein is separately performed on $S_3^{''}$, separately performed on $C_1^{''}$, and separately performed on $C_2^{''}$.

It should be noted that This step is optional. As shown in (b) in FIG. 6, intra-block interleaving may be performed on one or more of $S_3^{''}$, $C_1^{''}$, and $C_2^{''}$, or no interleaving may be performed. This is not limited in this embodiment of this application.

S1006. Modulate and map.

$C_1$, $C_2$, and $S_3$ are mapped to an 8ASK modulation symbol, denoted as $X$. $c_{1,i}$, $c_{2,i}$, and $s_{3,i}$ are mapped to $x_i$. $X = \{x_1,...,x_N\}$.

Further, $C_1$, $C_2$, and $S_3$ are mapped based on a mapping criterion.

For convenience, Table 3 is used as an example to describe the external features that need to be met in the mapping criterion. The mapping criterion may also have a plurality of other possible implementations, which is not limited in this embodiment.

It should be understood that the first row in Table 3 is modulation symbols in the constellation diagram from left to right corresponding to a case in which the modulation order is 8ASK. The first column is $c_{1,i}$, $s_{2,i}$, and $s_{3,i}$, which are bits selected from $C_1$, $S_2$, and $S_3$ respectively. During mapping, after the bits $c_{1,i}$, $s_{2,i}$, and $s_{3,i}$ are extracted from $C_1$, $S_2$, and $S_3$, based on the mapping criterion, the bits are determined to be mapped to $x_i$. For example, one bit 0 is extracted from $C_1$, one bit 0 is extracted from $S_2$, and one bit 1 is extracted from $S_3$, and based on the mapping criterion, the bits are determined to be mapped to -7.

As shown in Table 3, the mapping criterion satisfies the criterion 4: Each group of bits mapped to adjacent modulation symbols in the constellation diagram comply with a Gray code mapping rule.

In an example, as shown in Table 3, -7 and -5 are adjacent modulation symbols in the constellation diagram, and a group of bits corresponding to -7 are $c_{1,i}$=0, $c_{2,i}$=0, and $s_{3,i}$=1. A group of bits corresponding to -5 are $c_{1,i}$=0, $c_{2,i}$=1, and $s_{3,i}$=1, and a quantity of different characters of a position corresponding to each group of bits is one.

As shown in Table 3, the mapping criterion satisfies the criterion 2: In bits in $S_3$ corresponding to modulation symbols from left to right in the constellation diagram, bits corresponding to a first quarter of modulation symbols and a last quarter of modulation symbols are different from bits corresponding to a middle half of modulation symbols. For example, in Table 3, $s_{3,i}$ corresponding to modulation symbols from left to right in the constellation diagram is [1 1 0 0 0 0 1 1], and four symbols in the middle are different from four symbols on both sides.

**Table 3**

|          | -7 | -5 | -3 | -1 | 1 | 3 | 5 | 7 |
|----------|----|----|----|----|---|---|---|---|
| $c_{1,i}$ | 0  | 0  | 0  | 0  | 1 | 1 | 1 | 1 |
| $c_{2,i}$ | 0  | 1  | 1  | 0  | 0 | 1 | 1 | 0 |
| $s_{3,i}$ | 1  | 1  | 0  | 0  | 0 | 0 | 1 | 1 |

It should be noted that for convenience, in this embodiment, there is only one shaped bit sequence, that is, only one of the bit sequences ($U_3$) is used as an example for description. When this technical solution is implemented, a probability shaping technology may be further used for a plurality of bit sequences. This is not limited in this application.

For example, when the modulation order is 8ASK, probability shaping may be performed on at most two bit sequences at the same time. When the modulation order is 16ASK, probability shaping may be performed on at most three bits at the same time.

The following provides some supplementary descriptions based on the foregoing embodiment for the probability shaping solution of the plurality of bit sequences.

For a supplementary description of step S1002, refer to the supplementary description of step S602 in the method 600.

For a supplementary description of step S1003, refer to the supplementary description of step S603 in the method 600.

For a supplementary description of step S1006, refer to the supplementary description of S605 in the method 600.

In this embodiment of this application, a probability shaping technology is combined with a non-systematic code polar code, modulation and mapping are directly performed on all probability shaped bit sequences, and modulation and mapping are performed on some probability shaped bit sequences together with other bit sequences after polar code encoding, so that sub-channel capacity matching is implemented through flexible check, and the transmission rate is maximized.

Further, compared with an existing BICM modulation scheme, the polar encoding and modulation method 1000 provided in this application can maximize a transmission rate, and a large quantity of experimental results show that the polar encoding and modulation method 1000 has a general performance gain compared with an existing BICM modulation scheme.

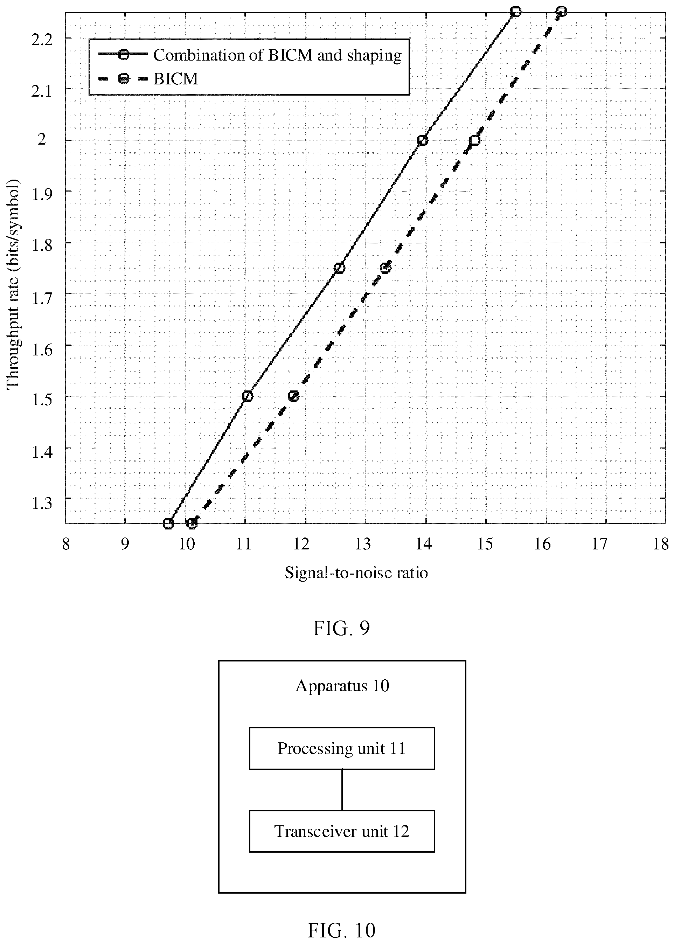

The following provides a performance comparison diagram between the method 1000 in this application and an existing BICM modulation scheme. In FIG. 9, BICM represents a bit interleaving encoding and modulation technology, and a curve corresponding to BICM represents that modulation is performed by using polar encoding and the BICM modulation technology. A curve corresponding to "BICM combination shaping" represents that the polar encoding and modulation method provided in this application is used, polar encoding is combined with a probability shaping technology, and modulation is performed by using the BICM modulation technology. The vertical coordinate is a current throughput (throughput) rate, and the unit is bits per symbol (bits per symbol). The horizontal coordinate is a signal-to-noise ratio required for a BLER to reach $1 e^{-2}$, or may be represented as an EsN0 required for a BLER to reach $1 e^{-2}$. It should be understood that, in the following figure, a leftward curve represents better performance. In other words, in a case in which signal-to-noise ratios are the same, a higher current throughput rate represents a higher transmission rate and better performance.

Refer to FIG. 9. FIG. 9 is a performance comparison diagram of the method 1000 and BICM modulation in this application in a case in which a modulation order is BLER=0.01 and 64QAM.

It can be learned that the solution in this embodiment of this application has a general performance gain compared with a baseline solution.

The foregoing describes in detail the polar encoding and modulation method and the demodulation and decoding method provided in this application. The following describes a polar encoding and modulation apparatus and a demodulation and decoding apparatus provided in this application.

In a possible design, FIG. 10 is a schematic block diagram of a polar encoding and modulation apparatus 10 according to this application. As shown in FIG. 10, an apparatus 10 includes a processing unit 11 and a transceiver unit 12. A processing unit 14 is configured to group to-be-encoded bit sequences to obtain a first bit sequence and a second bit sequence, where a quantity of bits included in the first bit sequence is greater than or equal to zero, and a quantity of bits included in the second bit sequence is greater than or equal to zero;

map the second bit sequence to obtain a third bit sequence;
perform polar transformation on the first bit sequence and a fourth bit sequence to obtain a fifth bit sequence, where the fourth bit sequence is obtained by performing polar transformation on the third bit sequence;
modulate the third bit sequence and the fifth bit sequence to obtain a modulation symbol sequence; and
a transceiver unit 12 is configured to send the modulation symbol sequence.

The third bit sequence obeys specific distribution.

Optionally, the processing unit 11 is specifically configured to: perform polar transformation on the third bit sequence to obtain a sixth bit sequence; and obtain the fourth bit sequence based on the sixth bit sequence, where a length of the fourth bit sequence is less than that of the sixth bit sequence. Optionally, the processing unit 11 is further configured to perform polar transformation on the third bit sequence to obtain a sixth bit sequence; and obtain the fourth bit sequence based on the sixth bit sequence, where a length of the fourth bit sequence is less than that of the sixth bit sequence. Optionally, polar encoding is performed on the third bit sequence to obtain a sixth bit sequence, where the third bit sequence includes B bit sequences, and the sixth bit sequence includes B bit sequences; and $k\_i$ bits are truncated from an $i^{th}$ bit sequence of the sixth bit sequence to form one bit sequence, to obtain the fourth bit sequence, where the fourth bit sequence includes B bit sequences, $i \in [1, B]$, $k\_i$ is a positive integer, i is a positive integer, and B is a positive integer.

Optionally, the fifth bit sequence includes a seventh bit sequence, and the seventh bit sequence is a sequence obtained by performing polar code encoding on one or more sequences in the first bit sequence and on the fourth bit sequence.

Optionally, the fifth bit sequence further includes an eighth bit sequence, and the eighth bit sequence is a sequence obtained by performing polar code encoding on a sequence other than the one or more sequences in the first bit sequence.

Optionally, a ninth bit sequence and a tenth bit sequence are modulated, where the ninth bit sequence and the tenth bit sequence are obtained by performing polar transformation on the third bit sequence and the fifth bit sequence.

Optionally, the processing unit 11 is further configured to modulate the third bit sequence and the fifth bit sequence based on a first criterion, where the first criterion includes that bits in the third bit sequence corresponding to first

$\dfrac{M}{4}$ and last $\dfrac{M}{4}$ modulation symbols in M modulation symbols arranged from left to right in a constellation diagram are different from bits in the third bit sequence corresponding to remaining modulation symbols, M=$2^m$, and m is a positive integer greater than or equal to 2.

Optionally, the first criterion further includes that distances between any two adjacent modulation symbols in a set of modulation symbols corresponding to a same bit in the fifth bit sequence are equal.

Optionally, the first criterion further includes that distances between any two adjacent modulation symbols in a set of modulation symbols corresponding to a same bit in the third bit sequence are equal.

Optionally, the first criterion further includes that there is only one different character mapped to the corresponding positions of each group of bits of the same modulation symbol, and N bits in each group of bits correspond to different bit sequences, where the third bit sequence includes B bit sequences, the fifth bit sequence includes A bit sequences, N=A+B, A is a positive integer, and B is a positive integer.

Optionally, the first criterion further includes that in the M modulation symbols from left to right in the constellation diagram, a bit in the third bit sequence corresponding to the ith modulation symbol is the same as a bit in the third bit sequence corresponding to the (M+1-i)th modulation symbol, M=$2^m$, and m is a positive integer greater than or equal to 2.

In another possible design, FIG. 10 is a schematic block diagram of a demodulation and decoding apparatus 10 according to this application. As shown in FIG. 10, an apparatus 10 includes a processing unit 11 and a transceiver unit 12.

The transceiver unit 12 is configured to obtain a modulation symbol sequence corresponding to a first bit sequence and a second bit sequence, where a quantity of bits included in the first bit sequence is greater than or equal to zero, and a quantity of bits included in the second bit sequence is greater than or equal to zero; and

> the processing unit 11 is configured to demodulate the modulation symbol sequence to obtain a third bit sequence and a fifth bit sequence, where
> the processing unit 11 is configured to decode the fifth bit sequence to obtain the first bit sequence; and
> the processing unit 11 is configured to map the third bit sequence to obtain the second bit sequence.

The third bit sequence obeys specific distribution.

The processing unit 11 is specifically configured to decode the fifth bit sequence to obtain the first bit sequence and a fourth bit sequence, where the fourth bit sequence is obtained by performing polar transformation on the third bit sequence.

The processing unit 11 is specifically configured to modulate the third bit sequence and the fifth bit sequence based on a first criterion, where the first criterion includes that bits in the third bit sequence corresponding to first $\dfrac{M}{4}$ and last $\dfrac{M}{4}$ modulation symbols in M modulation symbols arranged from left to right in a constellation diagram are different from bits in the third bit sequence corresponding to remaining modulation symbols, M=$2^m$, and m is a positive integer greater than or equal to 2.

The first criterion further includes that distances between any two adjacent modulation symbols in a set of modulation symbols corresponding to a same bit in the fifth bit sequence are equal.

The first criterion further includes that distances between any two adjacent modulation symbols in a set of modulation symbols corresponding to a same bit in the third bit sequence are equal.

The first criterion further includes that there is only one different character mapped to the corresponding positions of each group of bits of the same modulation symbol, and N bits in each group of bits correspond to different bit sequences, where the third bit sequence includes B bit sequences, the fifth bit sequence includes A bit sequences, N=A+B, A is a positive integer, and B is a positive integer.

The first criterion further includes that in the M modulation symbols from left to right in the constellation diagram, a bit in the third bit sequence corresponding to the ith modulation symbol is the same as a bit in the third bit sequence corresponding to the (M+1-i)th modulation symbol, M=$2^m$, and m is a positive integer greater than or equal to 2.

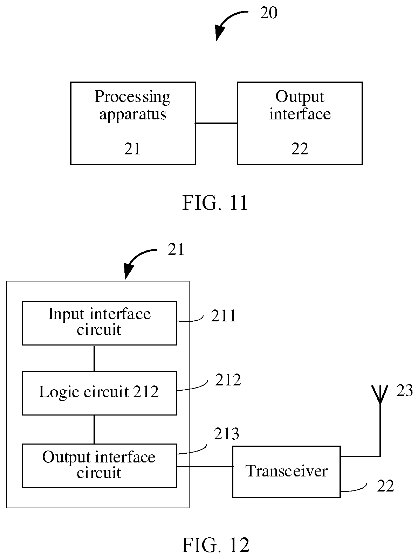

Refer to FIG. 11. FIG. 11 is a schematic diagram of a structure of a communication device 20 according to this application.

In an optional embodiment, the communication device 20 is configured to implement a function of polar encoding and modulation. The communication device 20 includes:

a processing apparatus 21, configured to group to-be-encoded bit sequences to obtain a first bit sequence and a second bit sequence, where a quantity of bits included in the first bit sequence is greater than or equal to zero, and a quantity of bits included in the second bit sequence is greater than or equal to zero, where map the second bit sequence to obtain a third bit sequence; perform polar transformation on the first bit sequence and a fourth bit sequence to obtain a fifth bit sequence, where the fourth bit sequence is obtained by performing polar transformation on the third bit sequence; and modulate the third bit sequence and the fifth bit sequence to obtain a modulation symbol sequence.

The communication device 20 may further include an output interface 22, configured to output the modulation symbol sequence.

The output interface may be an output circuit, or may be a transceiver.

Optionally, the transceiver may be connected to an antenna.

Herein, the communication device 20 may be a network device communicating with a terminal device, or may be a terminal device.

In a specific implementation, a processing apparatus 21 may be a processor, a chip, or an integrated circuit.

This application further provides a processing apparatus 21, configured to implement the polar encoding and modulation methods 400, 600, and 1000 in the foregoing method embodiments. Some or all of the processes in the methods 400, 600, 1000 may be implemented by hardware. When the process is implemented by using hardware, in a possible design, the processing apparatus 21 is a processor. Optionally, in another possible design, the processing apparatus 21 may alternatively be shown in FIG. 12.

Refer to FIG. 12. FIG. 12 is a schematic diagram of an internal structure of a processing apparatus 21. The processing apparatus 21 includes:

an input interface circuit 211, configured to obtain a to-be-encoded bit sequence;

a logic circuit 212, configured to group to-be-encoded bit sequences to obtain a first bit sequence and a second bit sequence, where a quantity of bits included in the first bit sequence is greater than or equal to zero, and a quantity of bits included in the second bit sequence is greater than or equal to zero; map the second bit sequence to obtain a third bit sequence; perform polar transformation on the first bit sequence and a fourth bit sequence to obtain a fifth bit sequence, where the fourth bit sequence is obtained by performing polar transformation on the third bit sequence; and modulate the third bit sequence and the fifth bit sequence to obtain a modulation symbol sequence; and

an output interface circuit 213, configured to output the modulation symbol sequence.

Optionally, some or all processes of the polar encoding and modulation methods 400, 600, and 1000 provided in this application may also be implemented by using software. In this case, the processing apparatus 21 may include a processor and a memory. The memory is configured to store a computer program, and the processor is configured to execute the computer program stored in the memory, to perform the polar encoding and modulation method in the method embodiments of this application.

Herein, the memory may be a physically independent unit. Alternatively, the memory and the processor may be integrated together. This is not limited in this application.

In another optional embodiment, the processing apparatus 21 may include only a processor, and a memory storing a computer program is located outside the processing apparatus. The processor is connected to the memory by using a circuit/wire, and is configured to read and execute the computer program stored in the memory, to perform any method embodiment.

It should be understood that the polar encoding and modulation methods 400, 600, and 1000 provided in this application are performed by a transmit end. For example, in the wireless communication system shown in FIG. 1, when a base station sends a signal, the base station is a transmit end. Therefore, this application further provides a network device and a terminal device. The network device and the terminal device have a function of implementing the foregoing polar encoding and modulation method.

In another optional embodiment, the communication device 20 is configured to implement a demodulation and decoding function. The communication device 20 includes:

an input interface circuit 211, configured to obtain a modulation symbol sequence corresponding to a first bit sequence and a second bit sequence, where a quantity of bits included in the first bit sequence is greater than or equal to zero, and a quantity of bits included in the second bit sequence is greater than or equal to zero; and

a processing apparatus 21, configured to demodulate the modulation symbol sequence to obtain a third bit sequence and a fifth bit sequence; decode the fifth bit sequence to obtain the first bit sequence; and map the third bit sequence to obtain the second bit sequence.

The input interface may be an input circuit, or may be a transceiver.

Optionally, the transceiver may be connected to an antenna.

Herein, the communication device 20 may be a network device communicating with a terminal device, or may be a terminal device.

In a specific implementation, a processing apparatus 21 may be a processor, a chip, or an integrated circuit.

This application further provides a processing apparatus 21, configured to implement the demodulation and decoding method 500 in the foregoing method embodiment. Some or all of the processes in the method 500 may be implemented by hardware. When the process is implemented by using hardware, in a possible design, the processing apparatus 21 is a processor. Optionally, in another possible design, the processing apparatus 21 may alternatively be shown in FIG. 12.

Refer to FIG. 12. FIG. 12 is a schematic diagram of an internal structure of a processing apparatus 21. The processing apparatus 21 includes:

an input interface circuit 211, configured to obtain a modulation symbol sequence corresponding to a first bit sequence and a second bit sequence; and

a logic circuit 212, configured to demodulate the modulation symbol sequence to obtain a third bit sequence and a fifth bit sequence; decode the fifth bit sequence to obtain the first bit sequence; and map the third bit sequence to obtain the second bit sequence.

Optionally, some or all processes of the demodulation and decoding method 500 provided in this application may also be implemented by using software. In this case, the processing apparatus 21 may include a processor and a memory. The memory is configured to store a computer program, and the processor is configured to execute the computer program stored in the memory, to perform the polar encoding and modulation method in the method embodiments of this application.

Herein, the memory may be a physically independent unit. Alternatively, the memory and the processor may be integrated together. This is not limited in this application.

In another optional embodiment, the processing apparatus 21 may include only a processor, and a memory storing a computer program is located outside the processing apparatus. The processor is connected to the memory by using a circuit/wire, and is configured to read and execute the computer program stored in the memory, to perform any method embodiment.

It should be understood that the demodulation and decoding method 500 provided in this application is performed by a receive end. For example, in the wireless communication system shown in FIG. 1, when a terminal device receives a signal, the terminal device is a receive end. Therefore, this application further provides a network device and a terminal device. The network device and the terminal device have a function of implementing the foregoing demodulation and decoding method.

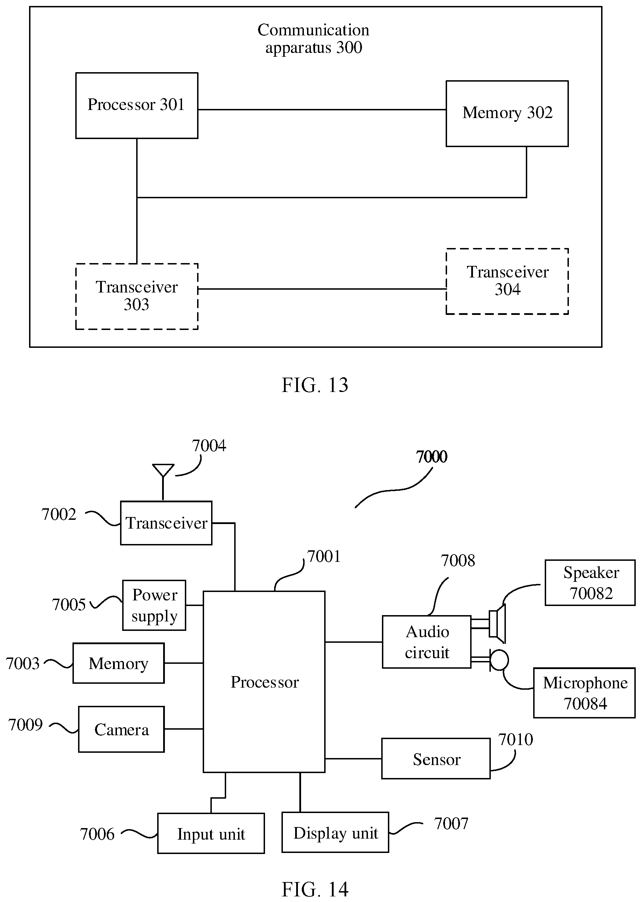

FIG. 13 is a schematic diagram of a structure of a communication apparatus. A communication apparatus 300 may be a network device, a server, or a centralized controller, or may be a chip, a chip system, a processor, or the like that supports the network device, the server, or the centralized controller in implementing the foregoing methods. The apparatus may be configured to implement the method performed by the receive end or the transmit end described in the foregoing method embodiment. For details, refer to the description in the foregoing method embodiment.

The apparatus 300 may include one or more processors 301. The processor 301 may also be referred to as a processing unit, and may implement a specific control function. The processor 301 may be a general-purpose processor, a dedicated processor, or the like. For example, it may be a baseband processor or a central processing unit. The baseband processor may be configured to process a communication protocol and communication data, and the central processing unit may be configured to process a communication apparatus (for example, a base station, a baseband chip, a terminal, a terminal chip, a DU, or a CU), execute a software program, and process data of the software program.

In an optional design, the processor 301 may alternatively store instructions and/or data, and the instructions and/or data may be run by the processor, so that the apparatus 300 performs the method described in the foregoing method embodiment.

In another optional design, the processor 301 may include a transceiver unit configured to implement sending and receiving functions. For example, the transceiver unit may be a transceiver circuit, an interface, an interface circuit, or a communication interface. The transceiver circuit, the interface, or the interface circuit that are configured to implement receiving and sending functions may be separated, or may be integrated together. The transceiver circuit, the interface, or the interface circuit may be configured to read or write code/data, or the transceiver circuit, the interface, or the interface circuit may be configured to transmit or transmit a signal.

In still another possible design, the apparatus 300 may include a circuit, and the circuit may implement the functions of reception, transmission, and communication in the foregoing method embodiment.

Optionally, the apparatus 300 may include one or more memories 302, and the memory 302 may store instructions. The instructions may be run on the processor, so that the apparatus 300 performs the method described in the foregoing method embodiment. Optionally, the memory may further store data. Optionally, the processor may alternatively store instructions and/or data. The processor and the memory may be separately disposed, or may be integrated together. For example, the correspondence described in the foregoing method embodiment may be stored in the memory or stored in the processor.

Optionally, the apparatus 300 may further include a transceiver 303 and/or an antenna 304. A processor 1501 may be referred to as a processing unit, and controls the apparatus 300. A transceiver 303 may be referred to as a transceiver unit, a transceiver, a transceiver circuit, a transceiver apparatus, a transceiver module, or the like, and is configured to implement a transceiver function.

Optionally, the apparatus 300 in this embodiment of this application may be configured to perform the methods 400, 500, 600, and 1000 in embodiments of this application.

The processor and the transceiver described in this application may be implemented on an integrated circuit (integrated circuit, IC), an analog IC, a radio frequency integrated circuit RFIC, a hybrid signal IC, an application specific integrated circuit (application specific integrated circuit, ASIC), a printed circuit board (printed circuit board, PCB), an electronic device, or the like. The processor and the transceiver each may be manufactured by using various IC processing technologies, for example, a complementary metal oxide semiconductor (complementary metal oxide semiconductor, CMOS), an n-type metal-oxide-semiconductor (n Metal-oxide-semiconductor, NMOS), a p-type metal oxide semiconductor (positive channel metal oxide semiconductor, PMOS), a bipolar junction transistor (Bipolar Junction Transistor, BJT), a bipolar CMOS (BiCMOS), silicon germanium (SiGe), and gallium arsenide (GaAs).

Refer to FIG. 14. FIG. 14 is a schematic diagram of a structure of a terminal device 7000 according to this application. As shown in FIG. 14, a terminal device 7000 includes a processor 7001. Optionally, the terminal device 7000 further includes a memory 7003 and a transceiver 7002. The processor 7001, the transceiver 7002, and the memory 7003 may communicate with each other by using an internal connection path, to transmit a control signal and/or a data signal. The memory 7003 is configured to store a computer program. The processor 7001 is configured to invoke and run the computer program from the memory 7003, to control the transceiver 7002 to receive and send a signal.

Optionally, the terminal device 7000 may further include an antenna 7004, configured to send, by using a radio signal, information or data output by the transceiver 7002.

The processor 7001 and the memory 7003 may be combined into a processing apparatus. The processor 7001 is configured to execute program code stored in the memory 7003 to implement the foregoing functions. During a specific implementation, the memory 7003 may alternatively be integrated into the processor 7001, or may be independent of the processor 7001.

The processor 7001 may be configured to perform an action internally implemented by the transmit end described in the foregoing method embodiment, for example, polar encoding and modulation. The transceiver 7002 may be configured to perform a receiving or sending action that is performed by the transmit end and described in the foregoing method embodiment, for example, sending a modulation symbol sequence. Alternatively, the transceiver 7002 may be an output interface or an input interface, and is integrated into the processor 7001.

The processor 7001 may be configured to perform an action internally implemented by the receive end described in the foregoing method embodiment, for example, demodulation and decoding. The transceiver 7002 may be configured to perform a receiving or sending action that is performed by the receive end and described in the foregoing method embodiment, for example, receiving a modulation symbol sequence. Alternatively, the transceiver 7002 may be an output interface or an input interface, and is integrated into the processor 7001.

Optionally, the terminal device 7000 may further include a power supply 7005, configured to supply power to various components or circuits in the terminal device.

In addition, to make functions of the terminal device more perfect, the terminal device 7000 may further include one or more of an input unit 7006, a display unit 7007, an audio frequency circuit 7008, a camera 7009, a sensor 610, and the like. The audio circuit may further include a loudspeaker 70082, a microphone 70084, and the like.

For example, the terminal device 7000 may be a terminal device in the wireless communication system shown in FIG. 1.

In addition, this application provides a computer-readable storage medium. The computer-readable storage medium stores computer instructions. When the computer instructions are run on a computer, so that the computer performs corresponding operations and/or procedures of the polar encoding and modulation methods 400, 500, 600, and 1000 in embodiments of this application.

This application further provides a computer program product. The computer program product includes computer program code. When the computer program code runs on a computer, so that the computer performs a corresponding operation and/or procedure of the polar encoding and modulation methods 400, 600, or 1000 or the demodulation and decoding method 500 in this embodiment of this application.

This application further provides a chip, including one or more processors. The one or more processors are configured to read and execute the computer program stored in the memory, to perform corresponding operations and/or procedures of the polar encoding and modulation methods 400, 600, and 1000 or the demodulation and decoding method 500 provided in this application.

Optionally, the chip further includes one or more memories, and the one or more memories and the one or more processors are connected to the memories by using a circuit or a wire. Further, optionally, the chip further includes a communication interface, and the one or more processors are connected to the communication interface.

Optionally, the communication interface may include an input interface and an output interface. The input interface is configured to receive a to-be-coded bit sequence. The processor obtains the to-be-coded bit sequence from the input interface, and performs polar encoding and modulation on the to-be-coded bit sequence by using the polar encoding and modulation methods 400, 600, and 1000 in embodiments of this application. The output interface is further configured to output a modulation symbol sequence obtained through polar encoding and modulation. Optionally, the communication interface may be an interface circuit. Specifically, the input interface may be an input interface circuit, and the output interface may be an output interface circuit.

Alternatively, optionally, the communication interface may include an input interface and an output interface. The input interface is configured to receive a modulation symbol sequence. The processor obtains a modulation symbol from the input interface, and performs demodulation and decoding on the modulation symbol sequence by using the demodulation and decoding method 500 in this embodiment of this application. The output interface is further configured to output a demodulated and decoded bit sequence. Optionally, the communication interface may be an interface circuit. Specifically, the input interface may be an input interface circuit, and the output interface may be an output interface circuit.

The apparatus described in the foregoing embodiments may be a network device or a terminal device. However, a range of the apparatus described in this application is not limited thereto, and a structure of the apparatus may not be limited to FIG. 13 or FIG. 14. The apparatus may be a stand-alone device or may be part of a larger device. For example, the apparatus may be:

(1) an independent IC, a chip, a chip system, or a subsystem;
(2) a set having one or more ICs. Optionally, the IC set may also include a storage component configured to store data and/or instructions;
(3) an ASIC, such as a modem (MSM);
(4) a module that can be embedded in other devices;
(5) a receiver, a terminal, an intelligent terminal, a cellular phone, a wireless device, a handset, a mobile unit, an on-board device, a network device, a cloud device, an artificial intelligence device, a machine device, a household device, a medical device, an industrial device, and the like; and
(6) others, and so on.

The chip in this embodiment of this application may be a field-programmable gate array (field-programmable gate array, FPGA), an application specific integrated circuit (application specific integrated circuit, ASIC), a system on chip (system on chip, SoC), a central processor unit (central processor unit, CPU), a network processor (Network Processor, NP), or a digital signal processing circuit (digital signal processor, DSP), or may be a micro controller (micro controller unit, MCU), a programmable logic device (programmable logic device, PLD), or other integrated chips.

The processor in this embodiment of this application may be an integrated circuit chip, and has a signal processing capability. In an implementation process, steps in the foregoing method embodiments can be implemented by using a hardware integrated logical circuit in the processor, or by using instructions in a form of software. The processor may be a general-purpose processor, a DSP, an ASIC, an FPGA, another programmable logical device, a discrete gate or transistor logic device, or a discrete hardware component. The general-purpose processor may be a microprocessor, or the processor may be any conventional processor or the like. The steps of the methods disclosed in embodiments of this application may be directly presented as being performed and completed by a hardware encoding processor, or performed and completed by a combination of hardware and a software module in an encoding processor. A software module may be located in a mature storage medium in the art, such as a random access memory, a flash memory, a read-only memory, a programmable read-only memory, an electrically erasable programmable memory, or a register. The storage medium is located in the memory, and a processor reads information in the memory and completes the steps in the foregoing methods in combination with hardware of the processor.

A memory in embodiments of this application may be a volatile memory or a nonvolatile memory, or may include both a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM) that is used as an external cache. Through example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus random access memory (direct rambus RAM, DR RAM). It should be noted that the memory of the systems and methods described in this specification includes but is not limited to these and any memory of another proper type.

With reference to the foregoing description, a person skilled in the art may be aware that the method in embodiments of this specification may be implemented by using hardware (for example, a logic circuit), software, or a combination of hardware and software. Whether these methods are performed by hardware or software depends on particular applications and design constraint conditions of the technical solutions. A person skilled in the art may use different methods to implement the described functions for each particular application, but it should not be considered that the implementation goes beyond the scope of this application.

When the foregoing functions are implemented in a form of software and sold or used as an independent product, the functions may be stored in a computer-readable storage medium. In this case, the technical solutions of this application essentially, or the part contributing to the conventional technology, or a part of the technical solutions may be implemented in a form of a software product. The computer software product is stored in a storage medium, and includes several instructions for instructing a computer device (which may be a personal computer, a server, a network device, or the like) to perform all or a part of the steps of the methods described in embodiments of this application. The foregoing storage medium includes: any medium that can store program code, such as a USB flash drive, a removable hard disk, a ROM, a RAM, a magnetic disk, or an optical disc.

**Claims**

1.  A polar encoding and modulation method, comprising:

    grouping (S401) to-be-encoded bit sequences to obtain a first bit sequence and a second bit sequence, wherein a quantity of bits comprised in the first bit sequence is greater than zero, and a quantity of bits comprised in the second bit sequence is greater than zero;
    mapping (S402) the second bit sequence to obtain a third bit sequence by obeying a non-uniform distribution for probability shaping;
    performing (S403) polar transformation on the first bit sequence and a fourth bit sequence to obtain a fifth bit sequence, wherein the fourth bit sequence is obtained by performing polar transformation on the third bit sequence;
    modulating (S404) the third bit sequence and the fifth bit sequence to obtain a modulation symbol sequence; and
    sending (S405) the modulation symbol sequence.

2.  The method according to claim 1, wherein the method further comprises:

    performing polar transformation on the third bit sequence to obtain a sixth bit sequence; and
    obtaining the fourth bit sequence based on the sixth bit sequence, wherein a length of the fourth bit sequence is less than that of the sixth bit sequence.

3.  The method according to claim 1, wherein the method further comprises:

    performing polar encoding on the third bit sequence to obtain a sixth bit sequence, wherein the third bit sequence comprises B bit sequences, and the sixth bit sequence comprises B bit sequences; and
    truncating $k\_i$ bits from an $i^{th}$ bit sequence of the sixth bit sequence to form one bit sequence, to obtain the fourth bit sequence, wherein the fourth bit sequence comprises B bit sequences, $i \in [1, B]$, $k\_i$ is a positive integer, i is a positive integer, and B is a positive integer.

4.  The method according to any one of claims 1 to 3, wherein
    the fifth bit sequence comprises a seventh bit sequence, and the seventh bit sequence is a sequence obtained by performing polar code encoding on one or more sequences in the first bit sequence and on the fourth bit sequence.

5.  The method according to claim 4, wherein
    the fifth bit sequence further comprises an eighth bit sequence, and the eighth bit sequence is a sequence obtained by performing polar code encoding on a sequence other than the one or more sequences in the first bit sequence.

6.  The method according to any one of claims 1 to 5, wherein the modulating the third bit sequence and the fifth bit sequence comprises:
    modulating a ninth bit sequence and a tenth bit sequence, wherein the ninth bit sequence and the tenth bit sequence are obtained by performing polar transformation on the third bit sequence and the fifth bit sequence.

7.  The method according to claim 1, wherein the modulating the third bit sequence and the fifth bit sequence comprises:

modulating the third bit sequence and the fifth bit sequence based on a first criterion, wherein the first criterion comprises that bits in the third bit sequence corresponding to first $\frac{M}{4}$ and last $\frac{M}{4}$ modulation symbols in M modulation symbols arranged from left to right in a constellation diagram are different from bits in the third bit sequence corresponding to remaining modulation symbols, $M=2^m$, and m is a positive integer greater than or equal to 2.

8. The method according to claim 7, wherein
the first criterion further comprises that distances between any two adjacent modulation symbols in a set of modulation symbols corresponding to a same bit in the fifth bit sequence are equal.

9. The method according to claim 7 or 8, wherein
the first criterion further comprises that distances between any two adjacent modulation symbols in a set of modulation symbols corresponding to a same bit in the third bit sequence are equal.

10. The method according to claim 7, wherein
the first criterion further comprises that there is only one different bit among a plurality of groups of bits mapped to a same modulation symbol, the one bit corresponds to a bit sequence, and N bits in each group of bits in the plurality of groups of bits correspond to different bit sequences, wherein the third bit sequence comprises B bit sequences, the fifth bit sequence comprises A bit sequences, N=A+B, A is a positive integer, and B is a positive integer.

11. A demodulation and decoding method, comprising:

obtaining (S501) a modulation symbol sequence corresponding to a first bit sequence and a second bit sequence, wherein a quantity of bits comprised in the first bit sequence is greater than zero, and a quantity of bits comprised in the second bit sequence is greater than zero;
demodulating (S502) the modulation symbol sequence to obtain a third bit sequence and a fifth bit sequence;
decoding (S503) the fifth bit sequence to obtain the first bit sequence; and
mapping (S504) the third bit sequence to obtain the second bit sequence, wherein the mapping is performed based on the mapping used in the polar encoding and modulation method according to any of the claims 1 to 10 to obtain the third bit sequence from the second bit sequence,
wherein the decoding the fifth bit sequence to obtain the first bit sequence comprises:
decoding the fifth bit sequence to obtain the first bit sequence and a fourth bit sequence, wherein the third bit sequence is obtained from the forth bit sequence based on polar transformation, the polar transformation being used in the polar encoding and modulation method according to any of the claims 1 to 10 to obtain the fourth bit sequence from the third bit sequence.

12. The method according to claim 10, wherein the demodulating the modulation symbol sequence comprises:
demodulating the modulation symbol sequence based on a first criterion, wherein the first criterion comprises that bits in the third bit sequence corresponding to first $\frac{M}{4}$ and last $\frac{M}{4}$ modulation symbols in M modulation symbols arranged from left to right in a constellation diagram are different from bits in the third bit sequence corresponding to remaining modulation symbols, $M=2^m$, and m is a positive integer greater than or equal to 2.

13. The method according to claim 12, wherein
the first criterion further comprises that distances between any two adjacent modulation symbols in a set of modulation symbols corresponding to a same bit in the fifth bit sequence are equal.

14. The method according to claim 12 or 13, wherein
the first criterion further comprises that distances between any two adjacent modulation symbols in a set of modulation symbols corresponding to a same bit in the third bit sequence are equal.

15. The method according to claim 12, wherein
the first criterion further comprises that there is only one different bit among a plurality of groups of bits mapped to a same modulation symbol, the one bit corresponds to a bit sequence, and N bits in each group of bits in the plurality of groups of bits correspond to different bit sequences, wherein the third bit sequence comprises B bit sequences, the fifth bit sequence comprises A bit sequences, N=A+B, A is a positive integer, and B is a positive integer.

16. A polar encoding and modulation apparatus, comprising:

a processing unit (11), configured to group to-be-encoded bit sequences to obtain a first bit sequence and a second bit sequence, wherein a quantity of bits comprised in the first bit sequence is greater than zero, and a quantity of bits comprised in the second bit sequence is greater than zero, wherein
the processing unit is configured to map the second bit sequence to obtain a third bit sequence by obeying a non-uniform distribution for probability shaping;
the processing unit is configured to perform polar transformation on the first bit sequence and a fourth bit sequence to obtain a fifth bit sequence, wherein the fourth bit sequence is obtained by performing polar transformation on the third bit sequence; and
the processing unit is configured to modulate the third bit sequence and the fifth bit sequence to obtain a modulation symbol sequence; and
a transceiver unit (12), configured to send the modulation symbol sequence.

17. The apparatus according to claim 16, wherein the processing unit is further configured to:

perform polar transformation on the third bit sequence to obtain a sixth bit sequence; and
obtain the fourth bit sequence based on the sixth bit sequence, wherein a length of the fourth bit sequence is less than that of the sixth bit sequence.

18. The apparatus according to claim 16,

performing polar encoding on the third bit sequence to obtain a sixth bit sequence, wherein the third bit sequence comprises B bit sequences, and the sixth bit sequence comprises B bit sequences; and
truncating k_i bits from an $i^{th}$ bit sequence of the sixth bit sequence to form one bit sequence, to obtain the fourth bit sequence, wherein the fourth bit sequence comprises B bit sequences, $i \in [1, B]$, k_i is a positive integer, i is a positive integer, and B is a positive integer.

19. The apparatus according to any one of claims 16 to 18, wherein
the fifth bit sequence comprises a seventh bit sequence, and the seventh bit sequence is a sequence obtained by performing polar code encoding on one or more sequences in the first bit sequence and on the fourth bit sequence.

20. The apparatus according to claim 19, wherein
the fifth bit sequence further comprises an eighth bit sequence, and the eighth bit sequence is a sequence obtained by performing polar code encoding on a sequence other than the one or more sequences in the first bit sequence.

21. The apparatus according to any one of claims 16 to 19, wherein the modulating the third bit sequence and the fifth bit sequence comprises:
modulating a ninth bit sequence and a tenth bit sequence, wherein the ninth bit sequence and the tenth bit sequence are obtained by performing polar transformation on the third bit sequence and the fifth bit sequence.

22. The apparatus according to claim 16, wherein the processing unit is further configured to:
modulate the third bit sequence and the fifth bit sequence based on a first criterion, wherein the first criterion comprises that bits in the third bit sequence corresponding to first $\frac{M}{4}$ and last $\frac{M}{4}$ modulation symbols in M modulation symbols arranged from left to right in a constellation diagram are different from bits in the third bit sequence corresponding to remaining modulation symbols, $M=2^m$, and m is a positive integer greater than or equal to 2.

23. The apparatus according to claim 22, wherein
the first criterion further comprises that distances between any two adjacent modulation symbols in a set of modulation symbols corresponding to a same bit in the fifth bit sequence are equal.

24. The apparatus according to claim 22 or 23, wherein
the first criterion further comprises that distances between any two adjacent modulation symbols in a set of modulation symbols corresponding to a same bit in the third bit sequence are equal.

25. The apparatus according to claim 22, wherein

the first criterion further comprises that there is only one different bit among a plurality of groups of bits mapped to a same modulation symbol, the one bit corresponds to a bit sequence, and N bits in each group of bits in the plurality of groups of bits correspond to different bit sequences, wherein the third bit sequence comprises B bit sequences, the fifth bit sequence comprises A bit sequences, N=A+B, A is a positive integer, and B is a positive integer.

26. A demodulation and decoding apparatus, comprising:

a transceiver unit (12), configured to obtain a modulation symbol sequence corresponding to a first bit sequence and a second bit sequence, wherein a quantity of bits comprised in the first bit sequence is greater than zero, and a quantity of bits comprised in the second bit sequence is greater than zero; and
a processing unit (11), configured to demodulate the modulation symbol sequence to obtain a third bit sequence and a fifth bit sequence, wherein
the processing unit is configured to decode the fifth bit sequence to obtain the first bit sequence; and
the processing unit is configured to map the third bit sequence to obtain the second bit sequence, wherein the mapping is performed based on the mapping used by the polar encoding and modulation apparatus according to any of the claims 16 to 25 to obtain the third bit sequence from the second bit sequence,
wherein the processing unit is further specifically configured to:
decode the fifth bit sequence to obtain the first bit sequence and a fourth bit sequence, wherein the third bit sequence is obtained from the fourth bit sequence based on polar transformation, the polar transformation being used by the polar encoding and modulation apparatus according to any of the claims 16 to 25 to obtain the fourth bit sequence from the third bit sequence.

27. The apparatus according to claim 26, wherein the processing unit is further specifically configured to:
modulate the third bit sequence and the fifth bit sequence based on a first criterion, wherein the first criterion comprises that bits in the third bit sequence corresponding to first $\dfrac{M}{4}$ and last $\dfrac{M}{4}$ modulation symbols in M modulation symbols arranged from left to right in a constellation diagram are different from bits in the third bit sequence corresponding to remaining modulation symbols, M=2$^m$, and m is a positive integer greater than or equal to 2.

28. The apparatus according to claim 27, wherein
the first criterion further comprises that distances between any two adjacent modulation symbols in a set of modulation symbols corresponding to a same bit in the fifth bit sequence are

29. The apparatus according to claim 27 or 28, wherein
the first criterion further comprises that distances between any two adjacent modulation symbols in a set of modulation symbols corresponding to a same bit in the third bit sequence are equal.

30. The apparatus according to claim 28, wherein
the first criterion further comprises that there is only one different bit among a plurality of groups of bits mapped to a same modulation symbol, the one bit corresponds to a bit sequence, and N bits in each group of bits in the plurality of groups of bits correspond to different bit sequences, wherein the third bit sequence comprises B bit sequences, the fifth bit sequence comprises A bit sequences, N=A+B, A is a positive integer, and B is a positive integer.

31. A communication apparatus, comprising:

a processor and a memory, wherein
the memory is configured to store a computer program; and
the processor is configured to execute the computer program stored in the memory, so that the communication apparatus performs the communication method according to any one of claims 1 to 10.

32. A communication apparatus, comprising:

a processor and a memory, wherein
the memory is configured to store a computer program; and
the processor is configured to execute the computer program stored in the memory, so that the communication apparatus performs the communication method according to any one of claims 11 to 15.

33. A computer-readable storage medium, wherein the computer-readable storage medium stores instructions, and when the computer instructions are run on a computer, the computer is enabled to perform the method according to any one of claims 1 to 10.

34. A computer-readable storage medium, wherein the computer-readable storage medium stores instructions, and when the computer instructions are run on a computer, the computer is enabled to perform the method according to any one of claims 11 to 15.


**Patentansprüche**

1. Verfahren zur Polarcodierung und -modulation, umfassend:

   Gruppieren (S401) von zu codierenden Bitsequenzen, um eine erste Bitsequenz und eine zweite Bitsequenz zu erlangen, wobei eine Menge von Bits, die in der ersten Bitsequenz enthalten ist, größer als Null ist, und eine Menge von Bits, die in der zweiten Bitsequenz enthalten ist, größer als Null ist;
   Abbilden (S402) der zweiten Bitsequenz, um eine dritte Bitsequenz durch Befolgen einer ungleichmäßigen Verteilung zur Wahrscheinlichkeitsformung zu erlangen;
   Durchführen (S403) einer Polartransformation an der ersten Bitsequenz und einer vierten Bitsequenz, um eine fünfte Bitsequenz zu erlangen, wobei die vierte Bitsequenz durch Durchführen von Polartransformation an der dritten Bitsequenz erlangt wird;
   Modulieren (S404) der dritten Bitsequenz und der fünften Bitsequenz, um eine Modulationssymbolsequenz zu erlangen; und
   Senden (S405) der Modulationssymbolsequenz.

2. Verfahren nach Anspruch 1, wobei das Verfahren ferner Folgendes umfasst:

   Durchführen einer Polartransformation an der dritten Bitsequenz, um eine sechste Bitsequenz zu erlangen; und
   Erlangen der vierten Bitsequenz basierend auf der sechsten Bitsequenz, wobei eine Länge der vierten Bitsequenz kleiner als jene der sechsten Bitsequenz ist.

3. Verfahren nach Anspruch 1, wobei das Verfahren ferner Folgendes umfasst:

   Durchführen von Polarcodierung an der dritten Bitsequenz, um eine sechste Bitsequenz zu erlangen, wobei die dritte Bitsequenz B Bitsequenzen umfasst und die sechste Bitsequenz B Bitsequenzen umfasst; und
   Abschneiden von $k\_i$ Bits aus einer i-ten Bitsequenz der sechsten Bitsequenz, um eine Bitsequenz auszubilden, um die vierte Bitsequenz zu erlangen, wobei die vierte Bitsequenz B Bitsequenzen umfasst, **i $\in$ [ 1, B], k_i eine positive ganze Zahl** ist, i eine positive ganze Zahl ist und B eine positive ganze Zahl ist.

4. Verfahren nach einem der Ansprüche 1 bis 3, wobei
   die fünfte Bitsequenz eine siebte Bitsequenz umfasst und die siebte Bitsequenz eine Sequenz ist, die durch Durchführen von Polarcodecodierung an einer oder mehreren Sequenzen in der ersten Bitsequenz und an der vierten Bitsequenz erlangt wird.

5. Verfahren nach Anspruch 4, wobei
   die fünfte Bitsequenz ferner eine achte Bitsequenz umfasst und die achte Bitsequenz eine Sequenz ist, die durch Durchführen von Polarcodecodierung an einer Sequenz, die sich von der einen oder den mehreren Sequenzen in der ersten Bitsequenz unterscheidet, erlangt wird.

6. Verfahren nach einem der Ansprüche 1 bis 5, wobei das Modulieren der dritten Bitsequenz und der fünften Bitsequenz Folgendes umfasst:
   Modulieren einer neunten Bitsequenz und einer zehnten Bitsequenz, wobei die neunte Bitsequenz und die zehnte Bitsequenz durch Durchführen von Polartransformation an der dritten Bitsequenz und der fünften Bitsequenz erlangt werden.

7. Verfahren nach Anspruch 1, wobei das Modulieren der dritten Bitsequenz und der fünften Bitsequenz Folgendes umfasst:
   Modulieren der dritten Bitsequenz und der fünften Bitsequenz basierend auf einem ersten Kriterium, wobei das erste Kriterium umfasst, dass sich Bits in der dritten Bitsequenz entsprechend dem ersten $\frac{M}{4}$ und dem letzten $\frac{M}{4}$ Modulationssymbol in M Modulationssymbolen, die von links nach rechts in einem Konstellationsdiagramm angeordnet sind, von Bits in der dritten Bitsequenz entsprechend den verbleibenden Modulationssymbolen unterscheiden, M = $2^m$ und m eine positive ganze Zahl größer oder gleich 2 ist.

8. Verfahren nach Anspruch 7, wobei
das erste Kriterium ferner umfasst, dass Abstände zwischen zwei beliebigen benachbarten Modulationssymbolen in einem Satz von Modulationssymbolen entsprechend demselben Bit in der fünften Bitsequenz gleich sind.

9. Verfahren nach Anspruch 7 oder 8, wobei
das erste Kriterium ferner umfasst, dass Abstände zwischen zwei beliebigen benachbarten Modulationssymbolen in einem Satz von Modulationssymbolen entsprechend demselben Bit in der dritten Bitsequenz gleich sind.

10. Verfahren nach Anspruch 7, wobei
das erste Kriterium ferner umfasst, dass es nur ein anderes Bit unter einer Vielzahl von Bitgruppen gibt, die auf demselben Modulationssymbol abgebildet ist, das eine Bit einer Bitsequenz entspricht und N Bits in jeder Bitgruppe in der Vielzahl von Bitgruppen unterschiedlichen Bitsequenzen entsprechen, wobei die dritte Bitsequenz B Bitsequenzen umfasst, die fünfte Bitsequenz A Bitsequenzen umfasst, N = A + B, A eine positive ganze Zahl ist und B eine positive ganze Zahl ist.

11. Verfahren zur Demodulation und Decodierung, umfassend:

Erlangen (S501) einer Modulationssymbolsequenz entsprechend einer ersten Bitsequenz und einer zweiten Bitsequenz, wobei eine Menge von Bits, die in der ersten Bitsequenz enthalten ist, größer als Null ist, und eine Menge von Bits, die in der zweiten Bitsequenz enthalten ist, größer als Null ist;
Demodulieren (S502) der Modulationssymbolsequenz, um eine dritte Bitsequenz und eine fünfte Bitsequenz zu erlangen;
Decodieren (S503) der fünften Bitsequenz, um die erste Bitsequenz zu erlangen; und
Abbilden (S504) der dritten Bitsequenz, um die zweite Bitsequenz zu erlangen, wobei das Abbilden basierend auf dem Abbilden durchgeführt wird, das bei dem Verfahren zur Polarcodierung und -modulation nach einem der Ansprüche 1 bis 10 verwendet wird, um die dritte Bitsequenz aus der zweiten Bitsequenz zu erlangen, wobei das Decodieren der fünften Bitsequenz, um die erste Bitsequenz zu erlangen, Folgendes umfasst:
Decodieren der fünften Bitsequenz, um die erste Bitsequenz und eine vierte Bitsequenz zu erlangen, wobei die dritte Bitsequenz aus der vierten Bitsequenz basierend auf Polartransformation erlangt wird, wobei die Polartransformation bei dem Verfahren zur Polarcodierung und -modulation nach einem der Ansprüche 1 bis 10 verwendet wird, um die vierte Bitsequenz aus der dritten Bitsequenz zu erlangen.

12. Verfahren nach Anspruch 10, wobei das Demodulieren der Modulationssymbolsequenz Folgendes umfasst:
Demodulieren der fünften Modulationssymbolsequenz basierend auf einem ersten Kriterium, wobei das erste Kriterium umfasst, dass sich Bits in der dritten Bitsequenz entsprechend dem ersten 4 *M* und dem letzten 4 Modulationssymbol in M Modulationssymbolen, die von links nach rechts in einem Konstellationsdiagramm angeordnet sind, von Bits in der dritten Bitsequenz entsprechend den verbleibenden Modulationssymbolen unterscheiden, M = $2^m$ und m eine positive ganze Zahl größer oder gleich 2 ist.

13. Verfahren nach Anspruch 12, wobei
das erste Kriterium ferner umfasst, dass Abstände zwischen zwei beliebigen benachbarten Modulationssymbolen in einem Satz von Modulationssymbolen entsprechend demselben Bit in der fünften Bitsequenz gleich sind.

14. Verfahren nach Anspruch 12 oder 13, wobei
das erste Kriterium ferner umfasst, dass Abstände zwischen zwei beliebigen benachbarten Modulationssymbolen in einem Satz von Modulationssymbolen entsprechend demselben Bit in der dritten Bitsequenz gleich sind.

15. Verfahren nach Anspruch 12, wobei
das erste Kriterium ferner umfasst, dass es nur ein anderes Bit unter einer Vielzahl von Bitgruppen gibt, die auf demselben Modulationssymbol abgebildet ist, das eine Bit einer Bitsequenz entspricht und N Bits in jeder Bitgruppe in der Vielzahl von Bitgruppen unterschiedlichen Bitsequenzen entsprechen, wobei die dritte Bitsequenz B Bitsequenzen umfasst, die fünfte Bitsequenz A Bitsequenzen umfasst, N = A + B, A eine positive ganze Zahl ist und B eine positive ganze Zahl ist.

16. Vorrichtung zur Polarcodierung und -modulation, umfassend:

eine Verarbeitungseinheit (11), die dazu konfiguriert ist, zu codierende Bitsequenzen zu gruppieren, um eine erste Bitsequenz und eine zweite Bitsequenz zu erlangen, wobei eine Menge von Bits, die in der ersten Bitsequenz enthalten ist, größer als Null ist, und eine Menge von Bits, die in der zweiten Bitsequenz enthalten ist, größer als Null ist, wobei
die Verarbeitungseinheit dazu konfiguriert ist, die zweite Bitsequenz abzubilden, um eine dritte Bitsequenz durch Befolgen einer ungleichmäßigen Verteilung zur Wahrscheinlichkeitsformung zu erlangen;
die Verarbeitungseinheit dazu konfiguriert ist, eine Polartransformation an der ersten Bitsequenz und einer vierten Bitsequenz durchzuführen, um eine fünfte Bitsequenz zu erlangen, wobei die vierte Bitsequenz durch Durchführen von Polartransformation an der dritten Bitsequenz erlangt wird; und die Verarbeitungseinheit dazu konfiguriert ist, die dritte Bitsequenz und die fünfte Bitsequenz zu modulieren, um eine Modulationssymbolsequenz zu erlangen; und
eine Sende-Empfangseinheit (12), die dazu konfiguriert ist, die Modulationssymbolsequenz zu senden.

17. Vorrichtung nach Anspruch 16, wobei die Verarbeitungseinheit ferner dazu konfiguriert ist:

eine Polartransformation an der dritten Bitsequenz durchzuführen, um eine sechste Bitsequenz zu erlangen; und die vierte Bitsequenz basierend auf der sechsten Bitsequenz zu erlangen, wobei eine Länge der vierten Bitsequenz kleiner als jene der sechsten Bitsequenz ist.

18. Vorrichtung nach Anspruch 16,

Durchführen von Polarcodierung an der dritten Bitsequenz, um eine sechste Bitsequenz zu erlangen, wobei die dritte Bitsequenz B Bitsequenzen umfasst und die sechste Bitsequenz B Bitsequenzen umfasst; und
Abschneiden von k_i Bits aus einer i-ten Bitsequenz der sechsten Bitsequenz, um eine Bitsequenz auszubilden, um die vierte Bitsequenz zu erlangen, wobei die vierte Bitsequenz B Bitsequenzen umfasst, $i \in$ **[ 1, B], k_i eine positive ganze Zahl** ist, i eine positive ganze Zahl ist und B eine positive ganze Zahl ist.

19. Vorrichtung nach einem der Ansprüche 16 bis 18, wobei
die fünfte Bitsequenz eine siebte Bitsequenz umfasst und die siebte Bitsequenz eine Sequenz ist, die durch Durchführen von Polarcodecodierung an einer oder mehreren Sequenzen in der ersten Bitsequenz und an der vierten Bitsequenz erlangt wird.

20. Vorrichtung nach Anspruch 19, wobei
die fünfte Bitsequenz ferner eine achte Bitsequenz umfasst und die achte Bitsequenz eine Sequenz ist, die durch Durchführen von Polarcodecodierung an einer Sequenz, die sich von der einen oder den mehreren Sequenzen in der ersten Bitsequenz unterscheidet, erlangt wird.

21. Vorrichtung nach einem der Ansprüche 16 bis 19, wobei das Modulieren der dritten Bitsequenz und der fünften Bitsequenz Folgendes umfasst:
Modulieren einer neunten Bitsequenz und einer zehnten Bitsequenz, wobei die neunte Bitsequenz und die zehnte Bitsequenz durch Durchführen von Polartransformation an der dritten Bitsequenz und der fünften Bitsequenz erlangt werden.

22. Vorrichtung nach Anspruch 16, wobei die Verarbeitungseinheit ferner dazu konfiguriert ist:
die dritte Bitsequenz und die fünfte Bitsequenz basierend auf einem ersten Kriterium zu modulieren, wobei das erste Kriterium umfasst, dass sich Bits in der dritten Bitsequenz entsprechend dem ersten $\frac{M}{4}$ und dem letzten $\frac{M}{4}$ Modulationssymbol in M Modulationssymbolen, die von links nach rechts in einem Konstellationsdiagramm angeordnet sind, von Bits in der dritten Bitsequenz entsprechend den verbleibenden Modulationssymbolen unterscheiden, $M = 2^m$ und m eine positive ganze Zahl größer oder gleich 2 ist.

23. Vorrichtung nach Anspruch 22, wobei
das erste Kriterium ferner umfasst, dass Abstände zwischen zwei beliebigen benachbarten Modulationssymbolen in einem Satz von Modulationssymbolen entsprechend demselben Bit in der fünften Bitsequenz gleich sind.

24. Vorrichtung nach Anspruch 22 oder 23, wobei
das erste Kriterium ferner umfasst, dass Abstände zwischen zwei beliebigen benachbarten Modulationssymbolen in einem Satz von Modulationssymbolen entsprechend demselben Bit in der dritten Bitsequenz gleich sind.

25. Vorrichtung nach Anspruch 22, wobei
das erste Kriterium ferner umfasst, dass es nur ein anderes Bit unter einer Vielzahl von Bitgruppen gibt, die auf demselben Modulationssymbol abgebildet ist, das eine Bit einer Bitsequenz entspricht und N Bits in jeder Bitgruppe in der Vielzahl von Bitgruppen unterschiedlichen Bitsequenzen entsprechen, wobei die dritte Bitsequenz B Bitsequenzen umfasst, die fünfte Bitsequenz A Bitsequenzen umfasst, N = A + B, A eine positive ganze Zahl ist und B eine positive ganze Zahl ist.

26. Vorrichtung zur Demodulation und Decodierung, umfassend:

eine Sende-Empfangseinheit (12), die dazu konfiguriert ist, eine Modulationssymbolsequenz entsprechend einer ersten Bitsequenz und einer zweiten Bitsequenz zu erlangen, wobei eine Menge von Bits, die in der ersten Bitsequenz enthalten ist, größer als Null ist, und eine Menge von Bits, die in der zweiten Bitsequenz enthalten ist, größer als Null ist; und
eine Verarbeitungseinheit (11), die dazu konfiguriert ist, die Modulationssymbolsequenz zu demodulieren, um eine dritte Bitsequenz und eine fünfte Bitsequenz zu erlangen, wobei
die Verarbeitungseinheit dazu konfiguriert ist, die fünfte Bitsequenz zu decodieren, um die erste Bitsequenz zu erlangen;
und
die Verarbeitungseinheit dazu konfiguriert ist, die dritte Bitsequenz abzubilden, um die zweite Bitsequenz zu erlangen, wobei das Abbilden basierend auf dem Abbilden durchgeführt wird, das durch die Vorrichtung zur Polarcodierung und -modulation nach einem der Ansprüche 16 bis 25 verwendet wird, um die dritte Bitsequenz aus der zweiten Bitsequenz zu erlangen,
wobei die Verarbeitungseinheit ferner speziell dazu konfiguriert ist:
die fünfte Bitsequenz zu decodieren, um die erste Bitsequenz und eine vierte Bitsequenz zu erlangen, wobei die dritte Bitsequenz aus der vierten Bitsequenz basierend auf Polartransformation erlangt wird, wobei die Polartransformation durch die Vorrichtung zur Polarcodierung und -modulation nach einem der Ansprüche 16 bis 25 verwendet wird, um die vierte Bitsequenz aus der dritten Bitsequenz zu erlangen.

27. Vorrichtung nach Anspruch 26, wobei die Verarbeitungseinheit ferner speziell dazu konfiguriert ist:
die dritte Bitsequenz und die fünfte Bitsequenz basierend auf einem ersten Kriterium zu modulieren, wobei das erste Kriterium umfasst, dass sich Bits in der dritten Bitsequenz entsprechend dem ersten und dem letzten Modulationssymbol in M Modulationssymbolen, die von links nach rechts in einem Konstellationsdiagramm angeordnet sind, von Bits in der dritten Bitsequenz entsprechend den verbleibenden Modulationssymbolen unterscheiden, $M = 2^m$ und m eine positive ganze Zahl größer oder gleich 2 ist.

28. Vorrichtung nach Anspruch 27, wobei
das erste Kriterium ferner umfasst, dass Abstände zwischen zwei beliebigen benachbarten Modulationssymbolen in einem Satz von Modulationssymbolen entsprechend demselben Bit in der fünften Bitsequenz gleich sind.

29. Vorrichtung nach Anspruch 27 oder 28, wobei
das erste Kriterium ferner umfasst, dass Abstände zwischen zwei beliebigen benachbarten Modulationssymbolen in einem Satz von Modulationssymbolen entsprechend demselben Bit in der dritten Bitsequenz gleich sind.

30. Vorrichtung nach Anspruch 28, wobei
das erste Kriterium ferner umfasst, dass es nur ein anderes Bit unter einer Vielzahl von Bitgruppen gibt, die auf demselben Modulationssymbol abgebildet ist, das eine Bit einer Bitsequenz entspricht und N Bits in jeder Bitgruppe in der Vielzahl von Bitgruppen unterschiedlichen Bitsequenzen entsprechen, wobei die dritte Bitsequenz B Bitsequenzen umfasst, die fünfte Bitsequenz A Bitsequenzen umfasst, N = A + B, A eine positive ganze Zahl ist und B eine positive ganze Zahl ist.

31. Kommunikationsvorrichtung, umfassend:

einen Prozessor und einen Speicher, wobei

der Speicher dazu konfiguriert ist, ein Computerprogramm zu speichern; und

der Prozessor dazu konfiguriert ist, das Computerprogramm, das in dem Speicher gespeichert ist, auszuführen, so dass die Kommunikationsvorrichtung das Kommunikationsverfahren nach einem der Ansprüche 1 bis 10 durchführt.

32. Kommunikationsvorrichtung, umfassend:

einen Prozessor und einen Speicher, wobei

der Speicher dazu konfiguriert ist, ein Computerprogramm zu speichern; und

der Prozessor dazu konfiguriert ist, das Computerprogramm, das in dem Speicher gespeichert ist, auszuführen, so dass die Kommunikationsvorrichtung das Kommunikationsverfahren nach einem der Ansprüche 11 bis 15 durchführt.

33. Computerlesbares Speichermedium, wobei das computerlesbare Speichermedium Anweisungen speichert, und wenn die Computeranweisungen auf einem Computer ausgeführt werden, der Computer in die Lage versetzt wird, das Verfahren nach einem der Ansprüche 1 bis 10 durchzuführen.

34. Computerlesbares Speichermedium, wobei das computerlesbare Speichermedium Anweisungen speichert, und wenn die Computeranweisungen auf einem Computer ausgeführt werden, der Computer in die Lage versetzt wird, das Verfahren nach einem der Ansprüche 11 bis 15 durchzuführen.

**Revendications**

1. Procédé de codage et de modulation polaire, comprenant :

le regroupement (S401) de séquences de bits à coder pour obtenir une première séquence de bits et une deuxième séquence de bits, dans lequel une quantité de bits comprise dans la première séquence de bits est supérieure à zéro, et une quantité de bits comprise dans la deuxième séquence de bits est supérieure à zéro ;

le mappage (S402) de la deuxième séquence de bits pour obtenir une troisième séquence de bits en obéissant à une distribution non uniforme pour la mise en forme de probabilités ;

la réalisation (S403) d'une transformation polaire sur la première séquence de bits et sur une quatrième séquence de bits pour obtenir une cinquième séquence de bits, dans lequel la quatrième séquence de bits est obtenue en réalisant une transformation polaire sur la troisième séquence de bits ;

la modulation (S404) de la troisième séquence de bits et de la cinquième séquence de bits pour obtenir une séquence de symboles de modulation ; et

l'envoi (S405) de la séquence de symboles de modulation.

2. Procédé selon la revendication 1, dans lequel le procédé comprend également :
la réalisation d'une transformation polaire sur la troisième séquence de bits pour obtenir une sixième séquence de bits ; et l'obtention de la quatrième séquence de bits sur la base de la sixième séquence de bits, dans lequel une longueur de la quatrième séquence de bits est inférieure à celle de la sixième séquence de bits.

3. Procédé selon la revendication 1, dans lequel le procédé comprend également :

la réalisation d'un codage polaire sur la troisième séquence de bits pour obtenir une sixième séquence de bits, dans lequel la troisième séquence de bits comprend B séquences de bits, et la sixième séquence de bits comprend B séquences de bits ; et

le troncage de k_i bits à partir d'une i-ème séquence de bits de la sixième séquence de bits pour former une séquence de bits, pour obtenir la quatrième séquence de bits, dans lequel la quatrième séquence de bits comprend B séquences de bits, $i \in [1, B]$, k_i est un entier positif, i est un entier positif, et B est un entier positif.

4. Procédé selon l'une quelconque des revendications 1 à 3, dans lequel
la cinquième séquence de bits comprend une septième séquence de bits, et la septième séquence de bits est une séquence obtenue en réalisant un codage de code polaire sur une ou plusieurs séquences dans la première séquence de bits et sur la quatrième séquence de bits.

**5.** Procédé selon la revendication 4, dans lequel
la cinquième séquence de bits comprend également une huitième séquence de bits, et la huitième séquence de bits est une séquence obtenue en réalisant un codage de code polaire sur une séquence autre que les une ou plusieurs séquences dans la première séquence de bits.

**6.** Procédé selon l'une quelconque des revendications 1 à 5, dans lequel la modulation de la troisième séquence de bits et de la cinquième séquence de bits comprend :
la modulation d'une neuvième séquence de bits et d'une dixième séquence de bits, dans lequel la neuvième séquence de bits et la dixième séquence de bits sont obtenues en réalisant une transformation polaire sur la troisième séquence de bits et la cinquième séquence de bits.

**7.** Procédé selon la revendication 1, dans lequel la modulation de la troisième séquence de bits et de la cinquième séquence de bits comprend :
la modulation de la troisième séquence de bits et de la cinquième séquence de bits sur la base d'un premier critère, dans lequel le premier critère comprend le fait que les bits dans la troisième séquence de bits correspondant aux premier $\frac{M}{4}$ et dernier $\frac{M}{4}$ symboles de modulation dans M symboles de modulation disposés de gauche à droite dans un diagramme de constellation sont différents des bits dans la troisième séquence de bits correspondant aux symboles de modulation restants, $M = 2^m$, et m est un entier positif supérieur ou égal à 2.

**8.** Procédé selon la revendication 7, dans lequel
le premier critère comprend également le fait que des distances entre deux quelconques symboles de modulation adjacents dans un ensemble de symboles de modulation correspondant à un même bit dans la cinquième séquence de bits sont égales.

**9.** Procédé selon la revendication 7 ou 8, dans lequel
le premier critère comprend également le fait que des distances entre deux quelconques symboles de modulation adjacents dans un ensemble de symboles de modulation correspondant à un même bit dans la troisième séquence de bits sont égales.

**10.** Procédé selon la revendication 7, dans lequel
le premier critère comprend également le fait qu'il n'y a qu'un seul bit différent parmi une pluralité de groupes de bits mappés sur un même symbole de modulation, le bit correspondant à une séquence de bits, et N bits dans chaque groupe de bits dans la pluralité de groupes de bits correspondent à des séquences de bits différentes, dans lequel la troisième séquence de bits comprend B séquences de bits, la cinquième séquence de bits comprend A séquences de bits, $N = A + B$, A est un entier positif, et B est un entier positif.

**11.** Procédé de démodulation et de décodage, comprenant :

l'obtention (S501) d'une séquence de symboles de modulation correspondant à une première séquence de bits et une deuxième séquence de bits, dans lequel une quantité de bits comprise dans la première séquence de bits est supérieure à zéro, et une quantité de bits comprise dans la deuxième séquence de bits est supérieure à zéro ;
la démodulation (S502) de la séquence de symboles de modulation pour obtenir une troisième séquence de bits et une cinquième séquence de bits ;
le décodage (S503) de la cinquième séquence de bits pour obtenir la première séquence de bits ; et
le mappage (S504) de la troisième séquence de bits pour obtenir la deuxième séquence de bits, dans lequel le mappage est réalisé sur la base du mappage utilisé dans le procédé de codage et de modulation polaire selon l'une quelconque des revendications 1 à 10 pour obtenir la troisième séquence de bits à partir de la deuxième séquence de bits,
dans lequel le décodage de la cinquième séquence de bits pour obtenir la première séquence de bits comprend :
le décodage de la cinquième séquence de bits pour obtenir la première séquence de bits et une quatrième séquence de bits, dans lequel la troisième séquence de bits est obtenue à partir de la quatrième séquence de bits sur la base d'une transformation polaire, la transformation polaire étant utilisée dans le procédé de codage et de modulation polaire selon l'une quelconque des revendications 1 à 10 pour obtenir la quatrième séquence de bits à partir de la troisième séquence de bits.

**12.** Procédé selon la revendication 10, dans lequel la démodulation de la séquence de symboles de modulation comprend :
la démodulation de la séquence de symboles de modulation sur la base d'un premier critère, dans lequel le premier critère comprend le fait que les bits dans la troisième séquence de bits correspondant aux premier $\frac{M}{4}$ et dernier $\frac{M}{4}$ symboles de modulation dans M symboles de modulation disposés de gauche à droite dans un diagramme de constellation sont différents des bits dans la troisième séquence de bits correspondant aux symboles de modulation restants, M = $2^m$, et m est un entier positif supérieur ou égal à 2.

13. Procédé selon la revendication 12, dans lequel
le premier critère comprend également le fait que des distances entre deux quelconques symboles de modulation adjacents dans un ensemble de symboles de modulation correspondant à un même bit dans la cinquième séquence de bits sont égales.

14. Procédé selon la revendication 12 ou 13, dans lequel
le premier critère comprend également le fait que des distances entre deux quelconques symboles de modulation adjacents dans un ensemble de symboles de modulation correspondant à un même bit dans la troisième séquence de bits sont égales.

15. Procédé selon la revendication 12, dans lequel
le premier critère comprend également le fait qu'il n'y a qu'un seul bit différent parmi une pluralité de groupes de bits mappés sur un même symbole de modulation, le bit correspondant à une séquence de bits, et N bits dans chaque groupe de bits dans la pluralité de groupes de bits correspondent à des séquences de bits différentes, dans lequel la troisième séquence de bits comprend B séquences de bits, la cinquième séquence de bits comprend A séquences de bits, N = A + B, A est un entier positif, et B est un entier positif.

16. Appareil de codace et de modulation polaire, commrenant :

une unité de traitement (11), configurée pour regrouper des séquences de bits à coder pour obtenir une première séquence de bits et une deuxième séquence de bits, dans lequel une quantité de bits comprise dans la première séquence de bits est supérieure à zéro, et une quantité de bits comprise dans la deuxième séquence de bits est supérieure à zéro, dans lequel
l'unité de traitement est configurée pour mapper la deuxième séquence de bits pour obtenir une troisième séquence de bits en obéissant à une distribution non uniforme pour la mise en forme de probabilités ;
l'unité de traitement est configurée pour réaliser une transformation polaire sur la première séquence de bits et sur une quatrième séquence de bits pour obtenir une cinquième séquence de bits, dans lequel la quatrième séquence de bits est obtenue en réalisant une transformation polaire sur la troisième séquence de bits ; et
l'unité de traitement est configurée pour moduler la troisième séquence de bits et la cinquième séquence de bits pour obtenir une séquence de symboles de modulation ; et
une unité émettrice-réceptrice (12), configurée pour envoyer la séquence de symboles de modulation.

17. Appareil selon la revendication 16, dans lequel l'unité de traitement est également configurée pour :

réaliser une transformation polaire sur la troisième séquence de bits pour obtenir une sixième séquence de bits ; et
obtenir la quatrième séquence de bits sur la base de la sixième séquence de bits, dans lequel une longueur de la quatrième séquence de bits est inférieure à celle de la sixième séquence de bits.

18. Appareil selon la revendication 16,

la réalisation d'un codage polaire sur la troisième séquence de bits pour obtenir une sixième séquence de bits, dans lequel la troisième séquence de bits comprend B séquences de bits, et la sixième séquence de bits comprend B séquences de bits ; et
le troncage de k_i bits à partir d'une i-ème séquence de bits de la sixième séquence de bits pour former une séquence de bits, pour obtenir la quatrième séquence de bits, dans lequel la quatrième séquence de bits comprend B séquences de bits, i∈[1, B], k_i est un entier positif, i est un entier positif, et B est un entier positif.

19. Appareil selon l'une quelconque des revendications 16 à 18, dans lequel

la cinquième séquence de bits comprend une septième séquence de bits, et la septième séquence de bits est une séquence obtenue en réalisant un codage de code polaire sur une ou plusieurs séquences dans la première séquence de bits et sur la quatrième séquence de bits.

20. Appareil selon la revendication 19, dans lequel
la cinquième séquence de bits comprend également une huitième séquence de bits, et la huitième séquence de bits est une séquence obtenue en réalisant un codage de code polaire sur une séquence autre que les une ou plusieurs séquences dans la première séquence de bits.

21. Appareil selon l'une quelconque des revendications 16 à 19, dans lequel la modulation de la troisième séquence de bits et de la cinquième séquence de bits comprend :
la modulation d'une neuvième séquence de bits et d'une dixième séquence de bits, dans lequel la neuvième séquence de bits et la dixième séquence de bits sont obtenues en réalisant une transformation polaire sur la troisième séquence de bits et la cinquième séquence de bits.

22. Appareil selon la revendication 16, dans lequel l'unité de traitement est également configurée pour :
moduler la troisième séquence de bits et la cinquième séquence de bits sur la base d'un premier critère, dans lequel le premier critère comprend le fait que les bits dans la troisième séquence de bits correspondant aux premier 4 et dernier $\frac{M}{4}$ symboles de modulation dans M symboles de modulation disposés de gauche à droite dans un diagramme de constellation sont différents des bits dans la troisième séquence de bits correspondant aux symboles de modulation restants, $M = 2^m$, et m est un entier positif supérieur ou égal à 2.

23. Appareil selon la revendication 22, dans lequel
le premier critère comprend également le fait que des distances entre deux quelconques symboles de modulation adjacents dans un ensemble de symboles de modulation correspondant à un même bit dans la cinquième séquence de bits sont égales.

24. Appareil selon la revendication 22 ou 23, dans lequel
le premier critère comprend également le fait que des distances entre deux quelconques symboles de modulation adjacents dans un ensemble de symboles de modulation correspondant à un même bit dans la troisième séquence de bits sont égales.

25. Appareil selon la revendication 22, dans lequel
le premier critère comprend également le fait qu'il n'y a qu'un seul bit différent parmi une pluralité de groupes de bits mappés sur un même symbole de modulation, le bit correspondant à une séquence de bits, et N bits dans chaque groupe de bits dans la pluralité de groupes de bits correspondent à des séquences de bits différentes, dans lequel la troisième séquence de bits comprend B séquences de bits, la cinquième séquence de bits comprend A séquences de bits, N = A + B, A est un entier positif, et B est un entier positif.

26. Appareil de démodulation et de décodage, comprenant :

une unité émettrice-réceptrice (12), configurée pour obtenir une séquence de symboles de modulation correspondant à une première séquence de bits et une deuxième séquence de bits, dans lequel une quantité de bits comprise dans la première séquence de bits est supérieure à zéro, et une quantité de bits comprise dans la deuxième séquence de bits est supérieure à zéro ; et
une unité de traitement (11), configurée pour démoduler la séquence de symboles de modulation pour obtenir une troisième séquence de bits et une cinquième séquence de bits, dans lequel l'unité de traitement est configurée pour décoder la cinquième séquence de bits pour obtenir la première séquence de bits ; et l'unité de traitement est configurée pour mapper la troisième séquence de bits pour obtenir la deuxième séquence de bits, dans lequel le mappage est réalisé sur la base du mappage utilisé par l'appareil de codage et de modulation polaire selon l'une quelconque des revendications 16 à 25 pour obtenir la troisième séquence de bits à partir de la deuxième séquence de bits,
dans lequel l'unité de traitement est également spécifiquement configurée pour :
décoder la cinquième séquence de bits pour obtenir la première séquence de bits et une quatrième séquence de bits, dans lequel la troisième séquence de bits est obtenue à partir de la quatrième séquence de bits sur la base d'une transformation polaire, la transformation polaire étant utilisée par l'appareil de codage et de modulation polaire selon l'une quelconque des revendications 16 à 25 pour obtenir la quatrième séquence de bits à partir de la troisième séquence de bits.

27. Appareil de détection selon la revendication 26, dans lequel l'unité de traitement est également spécifiquement configurée pour :
moduler la troisième séquence de bits et la cinquième séquence de bits sur la base d'un premier critère, dans lequel le premier critère comprend le fait que les bits dans la troisième séquence de bits correspondant aux premier $\frac{M}{4}$ et dernier 4 symboles de modulation dans M symboles de modulation disposés de gauche à droite dans un diagramme de constellation sont différents des bits dans la troisième séquence de bits correspondant aux symboles de modulation restants, $M = 2^m$, et m est un entier positif supérieur ou égal à 2.

28. Appareil selon la revendication 27, dans lequel
le premier critère comprend également le fait que des distances entre deux quelconques symboles de modulation adjacents dans un ensemble de symboles de modulation correspondant à un même bit dans la cinquième séquence de bits sont égales.

29. Appareil selon la revendication 27 ou 28, dans lequel
le premier critère comprend également le fait que des distances entre deux quelconques symboles de modulation adjacents dans un ensemble de symboles de modulation correspondant à un même bit dans la troisième séquence de bits sont égales.

30. Appareil selon la revendication 28, dans lequel
le premier critère comprend également le fait qu'il n'y a qu'un seul bit différent parmi une pluralité de groupes de bits mappés sur un même symbole de modulation, le bit correspondant à une séquence de bits, et N bits dans chaque groupe de bits dans la pluralité de groupes de bits correspondent à des séquences de bits différentes, dans lequel la troisième séquence de bits comprend B séquences de bits, la cinquième séquence de bits comprend A séquences de bits, N = A + B, A est un entier positif, et B est un entier positif.

31. Appareil de communication, comprenant :

un processeur et une mémoire, dans lequel
la mémoire est conficurée pour stocker un programme informatique ; et
le processeur est configuré pour exécuter le programme informatique stocké dans la mémoire, de sorte que l'appareil de communication réalise le procédé de communication selon l'une quelconque des revendications 1 à 10.

32. Appareil de communication, comprenant :

un processeur et une mémoire, dans lequel
la mémoire est configurée pour stocker un =- programme informatique ; et
le processeur est configuré pour exécuter le programme informatique stocké dans la mémoire, de sorte que l'appareil de communication réalise le procédé de communication selon l'une quelconque des revendications 11 à 15.

33. Support de stockage lisible par ordinateur, dans lequel le support de stockage lisible par ordinateur stocke des instructions, et lorsque les instructions informatiques fonctionnent sur un ordinateur, l'ordinateur est activé pour réaliser le procédé selon l'une quelconque des revendications 1 à 10.

34. Support de stockage lisible par ordinateur, dans lequel le support de stockage lisible par ordinateur stocke des instructions, et lorsque les instructions informatiques fonctionnent sur un ordinateur, l'ordinateur est activé pour réaliser le procédé selon l'une quelconque des revendications 11 à 15.

FIG. 1

FIG. 2

FIG. 3

Group to-be-encoded bit sequences to obtain a first bit sequence and a second bit sequence — S401

Map the second bit sequence to obtain a third bit sequence — S402

Perform polarization transformation on the first bit sequence and a fourth bit sequence to obtain a fifth bit sequence, where the fourth bit sequence is obtained by performing polarization transformation on the third bit sequence — S403

Modulate the third bit sequence and the fifth bit sequence to obtain a modulation symbol sequence — S404

Send the modulation symbol sequence — S405

FIG. 4

Obtain a modulation symbol sequence corresponding to a first bit sequence and a second bit sequence — S501

Demodulate the modulation symbol sequence to obtain a third bit sequence and a fifth bit sequence — S502

Decode the fifth bit sequence to obtain the first bit sequence — S503

Map the third bit sequence to obtain the second bit sequence — S504

FIG. 5

(a)

(b)

FIG. 6

FIG. 7

```
     ┌──────────┐      ┌──────────┐      ┌──────────┐   ┌ ─ ─ ─ ─ ┐   ┌──────────┐
     │  S1001   │      │  S1003   │      │  S1004   │   │  S1005  │   │  S1006   │
──▶  │  Group   │  ─▶  │ Channel  │  ─▶  │Cascade a │─▶ │Interleave│ ─▶│ Modulate │ ─▶
     │information│     │ encoding │      │long code │   │         │   │          │
     │   bits   │      └──────────┘      └──────────┘   └ ─ ─ ─ ─ ┘   └──────────┘
     └──────────┘            ▲
          │            ┌──────────┐
          └────────▶   │  S1002   │
                       │  Shape   │
                       └──────────┘
```

(a)

(b)

FIG. 8

FIG. 9

FIG. 10

20

| Processing apparatus 21 | Output interface 22 |
|---|---|

FIG. 11

21

Input interface circuit — 211

Logic circuit 212 — 212

Output interface circuit — 213

Transceiver — 22

23

FIG. 12

Communication
apparatus 300

| Processor 301 | Memory 302 |

| Transceiver 303 | Transceiver 304 |

FIG. 13

7004

7000

7002 Transceiver

7001

7008

Speaker 70082

7005 Power supply

Processor

Audio circuit

7003 Memory

Microphone 70084

7009 Camera

Sensor 7010

7006 Input unit

Display unit 7007

FIG. 14

## REFERENCES CITED IN THE DESCRIPTION

### Patent documents cited in the description

• WO 2019197037 A1

### Non-patent literature cited in the description

• Constellation shaping for bit-interleaved polar coded-modulation. **ZHOU DEKUN et al.** 27th annual international symposium on personal, indoor, and mobile radio communications (PIMRC). IEEE, 04 September 2016, 1-5